# EUROPEAN PATENT APPLICATION

(11) **EP 4 734 116 A1**
(43) Date of publication of application: **29.04.2026**
(21) Application number: 25208544.4
(22) Date of filing: 14.10.2025
(51) Int. Cl.: G11C 16/10, G11C 16/26, G11C 16/04, G11C 16/30

(54) **STORAGE DEVICE AND OPERATING METHOD OF THE SAME**

(30) Priority: 23.10.2024 KR 20240145722
(71) Applicant: Samsung Electronics Co., Ltd., Suwon-si, Gyeonggi-do 16677 (KR)
(72) Inventor: YOO, Hyunjoon, 16677 Suwon-si, Gyeonggi-do (KR); MOON, Young Sik, 16677 Suwon-si, Gyeonggi-do (KR); LEE, Jinwook, 16677 Suwon-si, Gyeonggi-do (KR); JEONG, Yong-Taek, 16677 Suwon-si, Gyeonggi-do (KR)
(74) Representative: Kuhnen & Wacker Patent- und Rechtsanwaltsbüro PartG mbB

(57) **Abstract**

A storage device (100) is provided. The storage device (100) includes: a first non-volatile memory device (300_1) that includes a first memory cell array (320_1) including a plurality of first memory cells and a first current management circuit (311_1) configured to output a shared clock signal (CLKs) to a shared clock line (Lsc); and a second non-volatile memory device (300_2) that includes a second memory cell array (320_2) including a plurality of second memory cells and a second current management circuit (311_2) configured to receive the shared clock signal (CLKs) from the shared clock line (Lsc) and preferentially output, in synchronization with the shared clock signal, a second current information code (CIc2) of a second memory operation for the plurality of second memory cells to a shared data line (Lc) during a first data output period.

## Description

### BACKGROUND

### 1. Field

The present disclosure relates to a storage device and an operation method of the storage device.

### 2. Description of Related Art

Recently, with the multifunctionality of an information communication device, larger capacity and higher integration of a memory device are required. In particular, in response to the demand for high integration and high performance for a non-volatile memory cell, research is being conducted on high stacking and high-speed input/output for the non-volatile memory cell. With the above trend, memory operations of the non-volatile memory device cause a high peak current, and occurrence of the peak current exceeding a certain level may seriously damage the overall performance and stability of a storage device including a plurality of non-volatile memory devices.

To solve this problem, power management technology within the storage device, management of a user system, and firmware improvements are being proposed.

### SUMMARY

One or more example embodiments provide a storage device that may efficiently avoid an overlap between peak power periods for a plurality of memory devices included in the storage device by using a shared input/output line, and a method of operating the storage device.

One or more example embodiments provide a storage device that may improve an efficiency of input/output operations for a shared input/output line, and a method of operating the storage device.

According to an aspect of an example embodiment, provided is a storage device including: a first non-volatile memory device that includes a first memory cell array including a plurality of first memory cells; and a first current management circuit configured to output a shared clock signal to a shared clock line; and a second non-volatile memory device that includes a second memory cell array including a plurality of second memory cells; and a second current management circuit configured to receive the shared clock signal from the shared clock line, and preferentially output, in synchronization with the shared clock signal, a second current information code of a second memory operation for the plurality of second memory cells to a shared data line during a first data output period.

According to an aspect of an example embodiment, provided is a storage device including: a first non-volatile memory device that includes a first memory cell array including a plurality of first memory cells and a first current management circuit configured to output a first flag signal to a shared data line during a first flag period and output a first current information code of a first memory operation for the plurality of first memory cells during a first data output period corresponding to the first flag period to the shared data line, and a second non-volatile memory device that includes a second memory cell array including a plurality of second memory cells and a second current management circuit configured to output, to the shared data line, a second flag signal before an output of the first flag signal during the first flag period and output a second current information code of a second memory operation for the plurality of second memory cells to the shared data line before an output of the first current information code during the first data output period.

According to an aspect of an example embodiment, provided is an operation method of a storage device, a plurality of non-volatile memory devices, the operation method including: receiving, by a corresponding non-volatile memory device among the plurality of non-volatile memory devices, a command for a memory operation from a controller; receiving, by the corresponding non-volatile memory device through a shared data line, a preceding flag signal for a preceding non-volatile memory device among the plurality of non-volatile memory devices, during a flag period before performing the memory operation; outputting, by the corresponding non-volatile memory device, a flag signal to the shared data line during the flag period after receiving the preceding flag signal; receiving, by the corresponding non-volatile memory device through the shared data line, a preceding current information code for the preceding non-volatile memory device during a data output period corresponding to the flag period; outputting, by the corresponding non-volatile memory device, a current information code to the shared data line after receiving the preceding current information code, during the data output period; and delaying, by the corresponding non-volatile memory device, the memory operation based on the preceding current information code.

According to a disclosed embodiment, provided is a storage device including: a first non-volatile memory device that includes a first memory cell array including a plurality of first memory cells; and a first current management circuit is configured to output a shared clock signal to a shared clock line; a second non-volatile memory device that includes a second memory cell array including a plurality of second memory cells; and a second current management circuit is configured to receive the shared clock signal, and preferentially output, in synchronization with the shared clock signal, a second current information code of a second memory operation for the plurality of second memory cells to a shared data line during a first data output period; and a controller that is connected with the first non-volatile memory device through a first input/output line separated from the shared data line and the shared clock line, connected with the second non-volatile memory device through a second input/output line separated from the shared data line and the shared clock line, and configured to provide an electric power budget to the first non-volatile memory device and the second non-volatile memory device.

### BRIEF DESCRIPTION OF DRAWINGS

Example embodiments will be more clearly understood from the following brief description taken in conjunction with the accompanying drawings. The accompanying drawings represent non-limiting, example embodiments as described herein.
FIG. 1 is a block diagram of a user system according to one or more embodiments.
FIG. 2 is a block diagram of a storage device according to one or more embodiments.
FIG. 3 is a block diagram of the controller according to one or more embodiments.
FIG. 4 is a block diagram of a non-volatile memory device according to one or more embodiments.
FIG. 5 is a block diagram of a current management circuit according to one or more embodiments.
FIG. 6 is a current information table according to one or more embodiments.
FIG. 7 illustrates a three-dimensional structure of the memory cell array according to one or more embodiments.
FIG. 8 is a block diagram of a non-volatile memory device according to one or more embodiments.
FIG. 9 is a block diagram illustrating a current management circuit according to one or more embodiments.
FIG. 10 is a flowchart of an operation method of a storage device according to one or more embodiments.
FIG. 11 is a timing diagram illustrating an operation method of the storage device according to one or more embodiments.
FIG. 12 is a timing diagram illustrating an operation method of the storage device according to one or more embodiments.
FIG. 13 is a timing diagram illustrating an operation method of the storage device according to one or more embodiments.
FIG. 14 is a timing diagram illustrating an operation method of the storage device according to one or more embodiments.
FIG. 15 is a timing diagram illustrating an operation method of the storage device according to one or more embodiments.
FIG. 16 illustrates a semiconductor package according to one or more embodiments.
FIG. 17 is a block diagram of a solid state drive (SSD) system to which the storage device according to one or more embodiments is applied.
FIG. 18 is a block diagram of a universal flash storage (UFS) system according to one or more embodiments.

### DETAILED DESCRIPTION

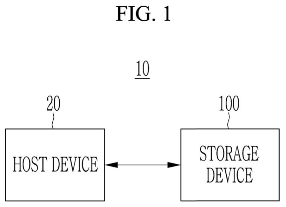

FIG. 1 is a block diagram of a user system according to one or more embodiments.

Referring to FIG. 1, a user system 10 may include a host device 20 and a storage device 100.

The user system 10 may be provided as one of computing systems such as, for example but not limited to, an ultra mobile PC (UMPC), a workstation, a net-book, a personal digital assistants (PDA), a portable computer, a web tablet, a wireless phone, a mobile phone, a smart phone, an e-book, a portable multimedia player (PMP), a portable game device, a navigation device, a black box, a digital camera, a digital multimedia broadcasting (DMB) player, a digital audio recorder, a digital audio player, a digital image recorder, a digital image player, a digital motion picture recorder, and a digital video player.

The host device 20 may transmit and/or receive a signal containing a plurality of data operation requests to and/or from the storage device 100. The plurality of data operation requests may include information about data, an address, and the like. For example, the host device 20 may exchange data and electric power information with the storage device 100 based on at least one of various interface protocols, such as a universal serial bus (USB) protocol, a multi-media card (MMC) protocol, a peripheral component interconnection (PCI) protocol, a PCI-express (PCI-E) protocol, an advanced technology attachment (ATA) protocol, a serial-ATA protocol, a parallel-ATA protocol, a small computer small interface (SCSI) protocol, an enhanced small disk interface (ESDI) protocol, an integrated drive electronics (IDE) protocol, a mobile industry processor interface (MIPI) protocol, and a universal flash storage (UFS) protocol.

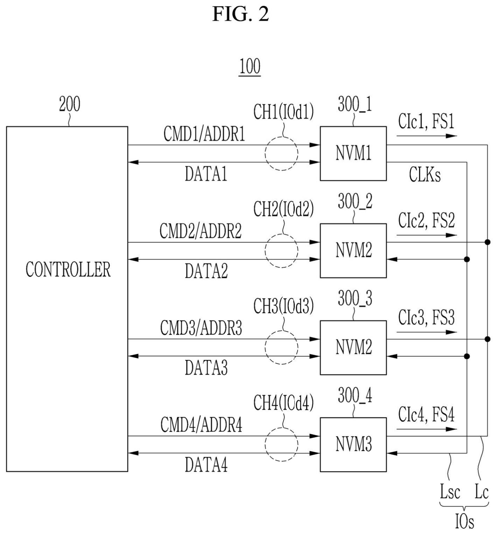

Although not shown, the host device 20 may include an electric power budget manager. The host device 20 may determine the entire electric power available to the user system 10 and determine how much of the determined entire electric power may be allocated to the storage device 100. The host device 20 may communicate an electric power budget allocated to the storage device 100 to a controller 200 (refer to FIG. 2), but is not limited thereto, and in some embodiments, the electric power budget for the storage device 100 may be provided via a power management integrated circuit (PMIC), may be predetermined, or may be determined internally by the controller 200 (refer to FIG. 2) within the storage device 100.

The electric power budget may be a maximum electric power value that the storage device 100 can use, and the electric power budget may also be a maximum current value or a maximum voltage value that can be allowed across a plurality of non-volatile memory devices within the storage device 100. When the plurality of non-volatile memory devices within the storage device 100 operate simultaneously and exceed the maximum current limit or the maximum electric power limit, it is difficult to ensure normal operation of the storage device 100.

FIG. 2 is a block diagram of a storage device according to one or more embodiments.

Referring to FIG. 2, the storage device 100 may include a controller 200 and a plurality of non-volatile memory devices 300_1 to 300_4.

The controller 200 may transmit and/or receive signals to and/or from the plurality of non-volatile memory devices 300_1 to 300_4 through a plurality of channels CH1 to CH4. The controller 200 may be physically or electrically connected to the plurality of non-volatile memory devices 300_1 to 300_4 via a plurality of input/output lines IOd1 to IOd4 corresponding to the plurality of channels CH1 to CH4.

The controller 200 may control the plurality of non-volatile memory devices 300_1 to 300_4 in response to a request of the host device 20. For example, the controller 200 may control the plurality of non-volatile memory devices 300_1 to 300_4 to read data DATA1 to DATA4 stored in the plurality of non-volatile memory devices 300_1 to 300_4 or to write the data DATA1 to DATA4 to the plurality of non-volatile memory devices 300_1 to 300_4 in response to a data operation request received from the host device 20.

The controller 200 may control a first non-volatile memory device 300_1 to perform program, read, and erase operations by providing a first address ADDR1, a first command CMD1, and a control signal to the first non-volatile memory device 300_1. In addition, first data DATA1 for memory operations may be transmitted and/or received through a first channel CH1. The controller 200 may transmit and/or receive the first address ADDR1, the first command CMD1, and the first data DATA1 through a first input/output line IOd1 corresponding to the first channel CH1, and in some embodiments, the first input/output line IOd1 may include a first command address line and a first data line that are separated from each other. The first address ADDR1 and the first command CMD1 are provided to the first non-volatile memory device 300_1 through the first command address line, and the first address ADDR1 and the first command CMD1 may be distinguished through a header signal output to the first command address line. The first data DATA1 may be transmitted and/or received to and/or from the first non-volatile memory device 300_1 through the first data line. In the present disclosure, program, read, and erase operations on memory cells in a non-volatile memory device are referred to as memory operations.

The controller 200 may control a second non-volatile memory device 300_2 to perform memory operations by providing a second address ADDR2, a second command CMD2, and a control signal to a second non-volatile memory device 300_2. In addition, second data DATA2 for the memory operations may be transmitted and/or received through the second channel CH2. The controller 200 may transmit and/or receive the second address ADDR2, the second command CMD2, and the second data DATA2 through a second input/output line IOd2 corresponding to the second channel CH2, and in some embodiments, the second input/output line IOd2 may include a second command address line and a second data line that are separated from each other. Through the second command address line, the second address ADDR2 and the second command CMD2 may be provided to the second non-volatile memory device 300_2, and the second address ADDR2 and the second command CMD2 may be distinguished through a header signal output to the second command address line. The second data DATA2 may be transmitted and/or received to and/or from the second non-volatile memory device 300_2 through the second data line.

The controller 200 may control a third non-volatile memory device 300_3 to perform memory operations by providing a third address ADDR3, a third command CMD3, and a control signal to the third non-volatile memory device 300_3. In addition, third data DATA3 for the memory operations may be transmitted and/or received through a third channel CH3. The controller 200 may transmit and/or receive the third address ADDR3, the third command CMD3, and the\a third data DATA3 through a third input/output line IOd3 corresponding to the third channel CH3, and in some embodiments, the third input/output line IOd3 may include a third command address line and a third data line that are separated from each other. The third address ADDR3 and the third command CMD3 may be provided to the third non-volatile memory device 300_3 through the third command address line, and the third address ADDR3 and the third command CMD3 may be distinguished through a header signal output to the third command address line. The third data DATA3 may be transmitted and/or received to and/or from the third non-volatile memory device 300_3 through the third data line.

The controller 200 may control a fourth non-volatile memory device 300_4 to perform memory operations by providing a fourth address ADDR4, a fourth command CMD4, and a control signal to the fourth non-volatile memory device 300_4. In addition, fourth data DATA4 for the memory operations may be transmitted and/or received through a fourth channel CH4. The controller 200 may transmit and/or receive the fourth address ADDR4, the fourth command CMD4, and the fourth data DATA4 through a fourth input/output line IOd4 corresponding to the fourth channel CH4, and in some embodiments, the fourth input/output line IOd4 may include a fourth command address line and a fourth data line that are separated from each other. The fourth address ADDR4 and the fourth command CMD4 may be provided to the fourth non-volatile memory device 300_4 through the fourth command address line, and the fourth address ADDR4 and the fourth command CMD4 may be distinguished through a header signal output to the fourth command address line. The fourth data DATA4 may be transmitted and/or received to and/or from the fourth non-volatile memory device 300_4 through the fourth data line.

The plurality of non-volatile memory devices 300_1 to 300_4 may respectively perform the memory operations on the data DATA1 to DATA4 in response to signals received from the controller 200. Each of the plurality of non-volatile memory devices 300_1 to 300_4 may include at least one memory cell array. The memory cell array may include a plurality of memory cells arranged in regions where a plurality of word lines and a plurality of bit lines intersect, and the plurality of memory cells may be non-volatile memory cells. The plurality of non-volatile memory devices 300_1 to 300_4 may include a NAND flash memory, a vertical NAND flash memory (VNAND), an NOR flash memory, a resistive random access memory (RRAM), a phase-change memory (PRAM), a magnetoresistive random access memory (MRAM), a ferroelectrics memory (FRAM), a spin transfer torque random access memory (STT-RAM), and the like, and may include a combination thereof. The plurality of non-volatile memory devices 300_1 to 300_4 may be memories in the form of memory dies, and accordingly, the storage device 100 may be a packaged chip including a plurality of dies, but is not limited thereto, and according to one or more embodiments, each of the plurality of non-volatile memory devices 300_1 to 300_4 may be a memory in the form of a single packaged chip.

The plurality of non-volatile memory devices 300_1 to 300_4 may be connected to each other via shared input/output lines IOs that are different from the first to fourth input/output lines IOd1 to IOd4. That is, the plurality of non-volatile memory devices 300_1 to 300_4 may share signals with each other, regardless of the first to fourth channels CH1 to CH4.

The plurality of non-volatile memory devices 300_1 to 300_4 may share a shared clock signal CLKs through a shared clock line Lsc of the shared input/output lines IOs. In addition, the plurality of non-volatile memory devices 300_1 to 300_4 may share flag signals FS1 to FS4 of flag bits and current information codes CIc1 to CIc4 of binary codes through shared data lines Lc of the shared input/output lines IOs. According to one or more embodiments, the plurality of non-volatile memory devices 300_1 to 300_4 may bi-directionally transmit and/or receive the flag signals FS1 to FS4 and the current information codes CIc1 to CIc4 through one shared data line Lc.

Each of the plurality of non-volatile memory devices 300_1 to 300_4 may delay the memory operations to be performed on the device based on the shared flag signals FS1 to FS4 and the current information codes CIc1 to CIc4 and a predetermined or received electric power budget. In some embodiments, the current information codes CIc1 to CIc4 may correspond to peak current information for the memory operations to be performed on each of the plurality of non-volatile memory devices 300_1 to 300_4. In some embodiments, the flag signals FS1 to FS4 may be reservation signals for an output of corresponding current information codes CIc1 to CIc4, and a flag period may be a reserved period for an output of the corresponding current information codes CIc1 to CIc4 as a period in which the flag signals FS1 to FS4 are output.

Although not shown, each of the plurality of non-volatile memory devices 300_1 to 300_4 may include a counter, and each of the plurality of non-volatile memory devices 300_1 to 300_4 may output the flag signals FS1 to FS4 and the current information codes CIc1 to CIc4 in synchronization with a specific cycle of a shared clock signal CLKs through the counter. In addition, each of the plurality of non-volatile memory devices 300_1 to 300_4 may identify a subject that outputs the flag signals FS1 to FS4 and the current information codes CIc1 to CIc4, which are output in synchronization with a specific cycle of a shared clock signal CLKs through the counter.

Among the plurality of non-volatile memory devices 300_1 to 300_4, the first non-volatile memory device 300_1 may output a shared clock signal CLKs on the shared clock line Lsc. In some embodiments, the first non-volatile memory device 300_1 may operate as a master device among the plurality of non-volatile memory devices 300_1 to 300_4 to output the shared clock signal CLKs or activate a flag period in which the flag signals FS1 to FS4 are output, but is not limited thereto. The activation of the flag period will be described later.

The first non-volatile memory device 300_1 may output a first flag signal FS1 and a first current information code CIc1 on the shared data line Lc in synchronization with a specific cycle of the shared clock signal CLKs. The first non-volatile memory device 300_1 may receive second to fourth flag signal FS2 to FS4 and second to fourth current information codes CIc2 to CIc4 that are output in synchronization with a specific cycle of the shared clock signal CLKs.

Among the plurality of non-volatile memory devices 300_1 to 300_4, the second to fourth non-volatile memory devices 300_2 to 300_4 may receive the shared clock signal CLKs through the shared clock line Lsc.

The second non-volatile memory device 300_2 may output the second flag signal FS2 and the second current information code CIc2 to the shared data line Lc in synchronization with a specific cycle of the shared clock signal CLKs, and may receive flag signals FS1, FS3, and FS4 and the current information codes CIc1, CIc3, and CIc4 synchronized with a specific cycle of the shared clock signal CLKs. The third non-volatile memory device 300_3 may output the third flag signal FS3 and the third current information code CIc3 to the shared data line Lc in synchronization with a specific cycle of the shared clock signal CLKs, and may receive the flag signals FS1, FS2, and FS4 and the current information codes CIc1, CIc2, and CIc4 that are output in synchronization with a specific cycle of the shared clock signal CLKs. The fourth non-volatile memory device 300_4 may output the fourth flag signal FS4 and the fourth current information code CIc4 to the shared data line Lc in synchronization with a specific cycle of the shared clock signal CLKs, and may receive the flag signals FS1 to FS3 and the current information codes CIc1 to CIc3 output in synchronization with a specific cycle of the shared clock signal CLKs.

In some embodiments, the plurality of non-volatile memory devices 300_1 to 300_4 may delay a memory operation to be performed in each device based on a current information code output from a preceding non-volatile memory device. In the present disclosure, a preceding non-volatile memory device means a non-volatile memory device that outputs a current information code in advance during the same data output interval.

The plurality of non-volatile memory devices 300_1 to 300_4 may avoid an overlap between peak power periods for the plurality of non-volatile memory devices 300_1 to 300_4 while simplifying a circuit design within the storage device 100 through transmitting and/or receiving the flag signals FS1 to FS4 and the current information codes CIc1 to CIc4 over the shared input/output lines IOs.

In FIG. 2, the storage device 100 is illustrated as including four non-volatile memory devices, but this is only an example and a number of non-volatile memory devices may vary In some embodiments.

In FIG. 2, it is illustrated that the controller 200 and each of the plurality of non-volatile memory devices 300_1 to 300_4 are connected via individual channels CH1 to CH4, but this is not limited thereto, and In some embodiments, at least two non-volatile memory devices may share one channel and may be connected to the controller 200 via the shared channel, and the storage device 100 may be driven in a multi-way manner.

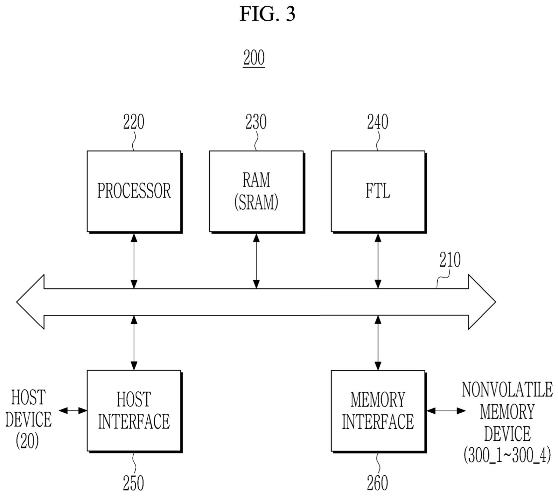

FIG. 3 is a block diagram of the controller according to one or more embodiments.

Referring to FIG. 3, the controller 200 may include a bus 210, a processor 220, a random access memory (RAM) 230, a flash translation layer 240 (hereinafter referred to as FTL), a host interface 250, and a memory interface 260.

The bus 210 may provide channels between components of the controller 200.

The processor 220 may control all operations of the controller 200 and may perform logical operations. The processor 220 may communicate with an external host device 20 through the host interface 250 and with the plurality of non-volatile memory devices 300_1 to 300_4 through the memory interface 260.

The RAM 230 may be used as an operating memory, a cache memory, or a buffer memory for the processor 220. The RAM 230 may store codes and instructions to be executed by the processor 220. The RAM 230 may store data processed by the processor 220. The RAM 230 may include a static RAM (SRAM).

The FTL 240 may provide an interface between the host device 20 and the plurality of non-volatile memory devices 300_1 to 300_4 to enable efficient use of the plurality of non-volatile memory devices 300_1 to 300_4. In some embodiments, the FTL 240, as a memory management module, may perform an address mapping operation, a garbage collection operation, a wear leveling operations, a read reclaim operation, and/or a log operation for degradation information of a memory block unit or a sub-block.

In some embodiments, the FTL 240 may be provided in hardware form as a dedicated circuit, but is not limited thereto. In some embodiments, the FTL 240 may be provided in a software form, and in this case, the FTL 240 may be loaded into the RAM 230 and operated by the processor 120. For example, the FTL 240 and an address mapping table (not shown) may be stored in the RAM 230. The FTL 240 and the address mapping table (not shown) stored in the RAM 230 may be operated by the processor 120.

The host interface 250 may be configured to communicate with the external host device 20 under control of the processor 220. The host interface 250 may be configured to communicate using at least one of various communication methods such as, for example but not limited to, a universal serial bus (USB), serial AT attachment (SATA), serial attached SCSI (SAS), high speed interchip (HSIC), a small computer system interface(SCSI), peripheral component interconnection (PCI), PCIexpress (PCIe), nonvolatile memory express (NVMe), a universal flash storage (UFS), secure digital (SD), a multimedia card (MMC), embedded MMC (eMMC), a dual in-line memory module (DIMM), a registered DIMM (RDIMM), and a load reduced DIMM (LRDIMM).

The memory interface 260 may be configured to communicate with the plurality of non-volatile memory devices 300_1 to 300_4 under the control of the processor 220. Referring to FIG. 2, as described above, the memory interface 260 may be capable of transmitting and/or receiving commands, addresses, and data to and/or from the plurality of non-volatile memory devices 300_1 to 300_4 via the input/output channels. The memory interface 260 may transmit a control signal to the non-volatile memory device 110 through a control channel. The memory interface 260 may be implemented to comply with standard protocols such as Toggle or Open NAND Flash Interface (ONFI).

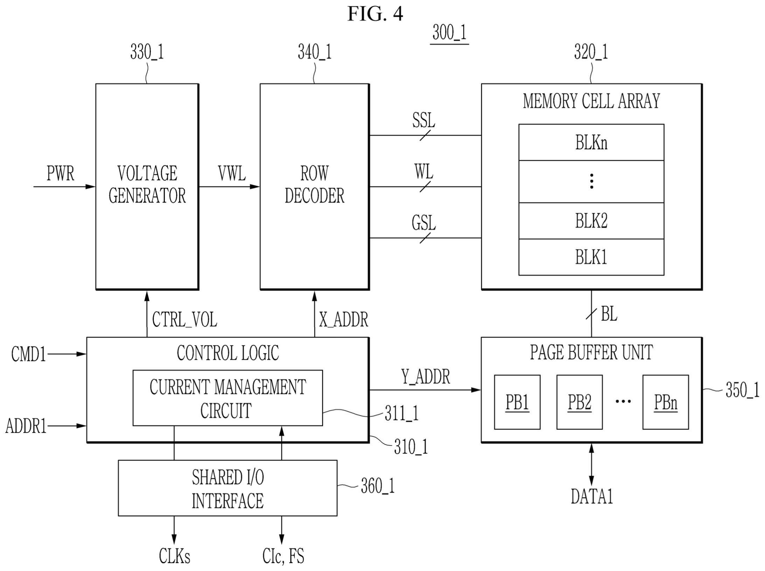

FIG. 4 is a block diagram of a non-volatile memory device according to one or more embodiments. Specifically, FIG. 4 shows configurations of the first non-volatile memory device 300_1 (refer to FIG. 2) that outputs the shared clock signal CLKs through the shared clock line Lsc (refer to FIG. 2).

Referring to FIG. 2 and FIG. 4, the first non-volatile memory device 300_1 may include a first control logic circuit 310_1, a first memory cell array 320_1, a first page buffer unit 350_1, a first voltage generator 330_1, a first row decoder 340_1, and a first shared input/output interface circuit 360_1. Although it is not illustrated in FIG. 4, the first non-volatile memory device 300_1 may further include the memory interface circuit 260 shown in FIG. 3, and may further include an additional component, for example, a column logic, a pre-decoder, a temperature sensor, a command decoder, an address decoder, and the like.

The first control logic circuit 310_1 may control the overall operations within the first non-volatile memory device 300_1. The first control logic circuit 310_1 may output various control signals in response to the first command CMD1 and/or first address ADDR1 from the memory interface circuit 260 (refer to FIG. 3). For example, the first control logic circuit 310_1 may output a voltage control signal CTRL_vol, a row address X-ADDR, and a column address Y-ADDR.

The first control logic circuit 310_1 may include a first current management circuit 311_1. The first current management circuit 311_1 may be connected to the shared input/output line IOs via the first shared input/output interface circuit 360_1. The first current management circuit 311_1 may output the shared clock signal CLK to the shared clock line Lsc and transmit and/or receive the flag signal FS and the current information code CIc to and/or from the shared data line Lc through the first shared input/output interface circuit 360_1. Specifically, the first current management circuit 311_1 may output the first flag signal FS1 and the first current information code CIc1 to the shared data line Lc, and receive the second to fourth flag signals FS2 to FS4 and the second to fourth current information codes CIc2 to CIc4 through the shared data line Lc.

The first current management circuit 311_1 may output the first flag signal FS1 during a flag period before performing the memory operation of the first non-volatile memory device 300_1, and may output the first current information code CIc1 for the memory operation in response to the output of the first flag signal FS1 during a data output period following the flag period. That is, the first current management circuit 311_1 may output the first flag signal FS1, which is a reservation signal for the first current information code CIc1, during a preceding flag period before outputting the first current information code CIc1 for the memory operation to be performed.

The first current management circuit 311_1 may receive at least a portion of the second to fourth flag signals FS2 to FS4 during the flag period, and may receive a current information code from a non-volatile memory device that outputs a flag signal during the data output period following the flag period.

The first current management circuit 311_1 may determine whether to delay a memory operation scheduled to be performed by the first non-volatile memory device 300_1 based on the current information code received from the preceding non-volatile memory device and the output first current information code CIc1. The first current management circuit 311_1 may control other components within the first non-volatile memory device 300_1 to delay the memory operation of the first non-volatile memory device 300_1.

In some embodiments, the first current management circuit 311_1 may receive a wake-up signal from the shared data line Lc before the flag period, and the first current management circuit 311_1 may output the shared clock signal CLK and activate the flag period based on the reception of the wake-up signal.

The first memory cell array 320_1 may include a plurality of memory blocks BLK1 to BLKz, and each of the plurality of memory blocks BLK1 to BLKz may include a plurality of memory cells. The first memory cell array 320_1 may be connected to the first page buffer unit 350_1 via the bit line BL, and to the first row decoder 340_1 via a word line WL, a string selection line SSL, and a ground selection line GSL.

In an embodiment, the first memory cell array 320_1 may include a three-dimensional memory cell array, and the three-dimensional memory cell array may include a plurality of NAND strings. Each NAND string may contain memory cells each connected to word lines stacked vertically on the substrate. In an example embodiment, the first memory cell array 320_1 may include a two-dimensional memory cell array, and the two-dimensional memory cell array may include a plurality of NAND strings arranged along row and column directions.

The first page buffer unit 350_1 may include a plurality of page buffers PB1 to PBn (n is an integer greater than or equal to 3), and the plurality of page buffers PB1 to PBn may be connected with the memory cells through the plurality of bit lines BL, respectively. The first page buffer unit 350_1 may select at least one bit line among the plurality of bit lines BL in response to the column address Y-ADDR. The first page buffer unit 350_1 may operate as a write driver or a detection amplifier depending on an operating mode. For example, during a program operation, the first page buffer unit 350_1 may apply a bit line voltage corresponding to the first data DATA1 to be programmed to a selected bit line. During a read operation, the first page buffer unit 350_1 may detect the first data DATA1 stored in the memory cell by detecting a current or voltage of the selected bit line.

The first voltage generator 330_1 may receive electric power PWR from an outside of the first non-volatile memory device 330_1 and may generate various types of voltages to perform memory operations such as program, read, and erase operations based on a voltage control signal CTRL_vol. For example, the first voltage generator 330_1 may generate a program voltage, a read voltage, a program verify voltage, an erase voltage, and the like, as a word line voltage VWL.

The first row decoder 340_1 may select one from a plurality of word lines WL in response to the row address X-ADDR, and may select one from a plurality of string selection lines SSL. For example, during the program operation, the first row decoder 340_1 may apply the program voltage and the program verify voltage to the selected word line, and during the read operation, may apply the read voltage to the selected word line.

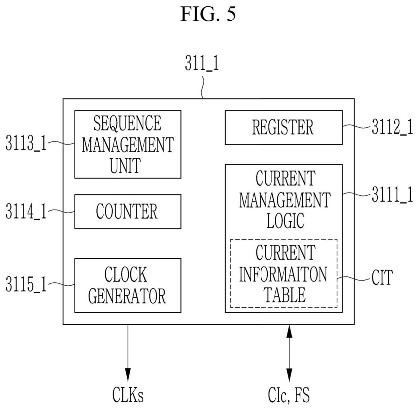

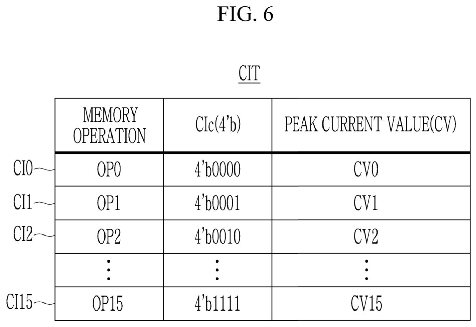

FIG. 5 is a block diagram of a current management circuit according to one or more embodiments. FIG. 6 is a current information table according to one or more embodiments. Specifically, FIG. 5 illustrates a current management circuit of the first non-volatile memory device 300_1 (refer to FIG. 2) that outputs the shared clock signal CLKs through the shared clock line Lsc (refer to FIG. 2).

Referring to FIG. 2 and FIG. 4 to FIG. 6, the first current management circuit 311_1 may include a first current management logic 3111_1, a first register 3112_1, a first sequence management unit 3113_1, a first counter 3114_1, and a clock generator 3115_1.

The first current management logic 3111_1 may be a circuit that processes information of signals input and/or output from the first shared input/output interface circuit 360_1, and may control the overall operations of the first current management circuit 311_1 and perform a logical operation.

The first current management logic 3111_1 may control to output the first flag signal FS1 and receive the second to fourth flag signals FS2 to FS4 based on a predetermined sequence during the flag period before performing the memory operation of the first non-volatile memory device 300_1. For example, the predetermined sequence may be first to fourth flag signals FS1 to FS4 in an ascending order.

The first current management logic 3111_1 may determine a sequence of current information codes in the data output period based on an output sequence of the first to fourth flag signals FS1 to FS4 in the flag period.

The first current management logic 3111_1 may control to output the first current information code CIc1 and receive the second to fourth current information codes CIc2 to CIc4 in a sequence of the current information codes during a subsequent data output period based on the determined sequence of the current information codes. The first current management logic 3111_1 may control an output of the first current information code CIc1 during the subsequent data output period in response to the output of the first flag signal FS1 in the flag period.

The first current management logic 3111_1 may determine a delay of a memory operation based on the current information code of the preceding non-volatile memory device that is received during the data output period and the output first current information code CIc1, and control the memory operation of the first non-volatile memory device 300_1 to be delayed.

The first current management logic 3111_1 may determine whether to delay memory operations using a current information table CIT. The first current management logic 3111_1 may obtain a peak current sum of peak current values corresponding to the current information code of the preceding non-volatile memory device received during the data output period and the output first current information code CIc1 by using the current information table CIT. The first current management logic 3111_1 may compare the obtained peak current sum of the peak current values with the electric power budget, and may determine to delay the memory operation when a sum of the obtained peak current is greater than the electric power budget PB. In some embodiments, the electric power budget may be predetermined or received from the controller 200.

Referring to FIG. 6, for example, the current information code CIc may have a bit count of 4 bits, and the current information table CIT may include 0th to 16th peak current information CI0 to CI15 for 0th to 16th memory operations OP0 to OP15 corresponding to the bit count of the current information code CIc.

Each of the 0th to fifteenth peak current information CI0 to CI15 may include a current information code CIc and a peak current value CV corresponding to each of the 0th to fifteenth memory operations OP0 to OP15.

The 0th memory operations OPO to the fifteenth memory operation OP15 may be memory operations that are performed in the first non-volatile memory device 300_1 and may consume electric power by generating a peak current and the like, and may include an erase operation that generates an erase voltage, a program operation that generates a program voltage in a word line WL, a precharge operation that applies a precharge voltage to a bit line, and a verify operation that provides a verify voltage to a word line during the program operation. A 0th fifteenth peak current value CV0 to a fifteenth peak current value CV15 corresponding to the 0th memory operations OP0 to the fifteenth memory operation OP15 may represent peak current values required when the first non-volatile memory device 300_1 performs the 0th memory operations OPO to the fifteenth memory operation OP15, respectively.

The first current management logic 3111_1 may obtain the peak current sum by adding the peak current value CV corresponding to the received preceding current information code and the peak current value CV corresponding to the output first current information code CIc1 using the current information table CIT. The first current management logic 3111_1 may compare the obtained peak current sum with the electric power budget, and may control the memory operation of the first non-volatile memory device 300_1 to be delayed when the peak current sum is greater than the electric power budget. In some embodiments, the electric power budget may be predetermined or received from the controller 200.

Although the current information table CIT is illustrated as being embedded in the first current management logic 3111_1 in FIG. 5, it is not limited thereto and, In some embodiments, the current information table CIT may be stored in a memory external to the first current management logic 3111_1.

The first register 3112_1 may store intermediate data generated during information processing and a logical operation of the first current management logic 3111_1. The intermediate data may include a sequence of the current information code determined in the flag period, the peak current value CV corresponding to the current information code of the preceding non-volatile memory device, the peak current value CV corresponding to the first current information code CIc1, and delay time information of the memory operation.

The first sequence management unit 3113_1 may control an operation sequence of the first non-volatile memory device 300_1 based on the first command CMD1 received from the controller 200. The first sequence management unit 3113_1 may control the operation sequence of the first non-volatile memory device 300_1 such that the memory operation is delayed in response to a delay decision of the first current management logic 3111_1 regarding the memory operation. In FIG. 5, the first sequence management unit 3113_1 is illustrated as being included in the first current management circuit 311_1, but is not limited thereto, and the first sequence management unit 3113_1 may be implemented as a component of the first control logic circuit 310_1 located external to the first current management circuit 311_1.

The first counter 3114_1 may count a clock cycle of the shared clock signal CLKs output from the clock generator 3115_1. The first current management logic 3111_1 may identify a transmission time for the first flag signal FS1 and the first current information code CIc1 through the first counter 3114_1, and identify the second to fourth flag signals FS2 to FS4 and the second to fourth current information codes CIc2 to CIc4 received from the shared data line Lc. In some embodiments, the first counter 3114_1 may be implemented as embedded in the first current management logic 3111_1.

The clock generator 3115_1 may generate shared clock signal CLKs under control of first current management logic 3111_1. In some embodiments, in response to the first current management logic 3111_1 receiving a wake-up signal from the shared data line Lc, the clock generator 3115_1 may generate a shared clock signal CLKs and output the shared clock signal CLKs to the shared clock line Lsc. Although not shown, In some embodiments, the clock generator 3115_1 may include an oscillator.

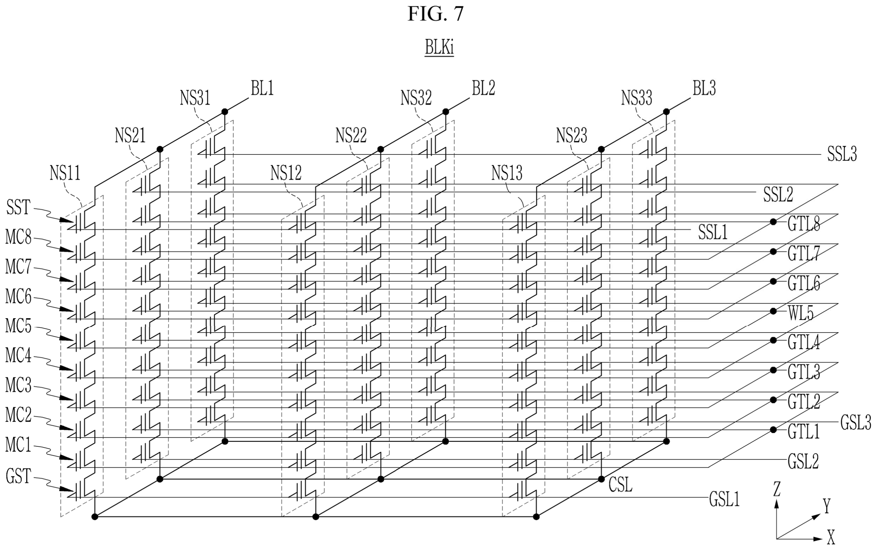

FIG. 7 illustrates a three-dimensional structure of the memory cell array according to one or more embodiments. Specifically, when the first non-volatile memory device 300_1 is implemented as a 3D V-NAND type flash memory, each of the plurality of memory blocks BLK1 to BLKz included in the first memory cell array 320_1 may be expressed as an equivalent circuit as illustrated in FIG. 7.

A memory block BLKi shown in FIG. 7 may be one of the plurality of memory blocks BLK1 to BLKz shown in FIG. 4. The memory block BLKi may represent a three-dimensional memory block having a three-dimensional structure on a substrate, and for example, a plurality of memory NAND strings included in the memory block BLKi may be formed in a direction perpendicular to the substrate.

Referring to FIG. 7, the memory block BLKi may include a plurality of memory NAND strings NS11 to NS33 connected between bit lines BL1, BL2, and BL3 and a common source line CSL. Each of the plurality of memory NAND strings NS11 to NS33 may include a string selection transistor SST, a plurality of memory cells MC1 to MC8, and a ground selection transistor GST. FIG. 7 illustrates a plurality of memory NAND strings NS11 to NS33 each containing eight memory cells MC1 to MC8, but is not limited thereto.

The string selection transistor SST may be connected to corresponding string selection lines SSL1, SSL2, and SSL3. The plurality of memory cells MC1 to MC8 may be connected to corresponding gate lines GTL1 to GTL8, respectively. The gate lines GTL1 to GTL8 may correspond to word lines, and some of the gate lines GTL1 to GTL8 may correspond to dummy word lines. The ground selection transistor GST may be connected to the corresponding ground selection lines GSL1, GSL2, and GSL3. The string selection transistor SST may be connected to the corresponding bit lines BL1, BL2, and BL3, and the ground selection transistor GST may be connected to the common source line CSL.

Word lines (e.g., WL1) of the same height may be commonly connected, and ground selection lines GSL1, GSL2, and GSL3 and string selection lines SSL1, SSL2, and SSL3 may be separated from each other. In FIG. 7, it is illustrated that the memory block BLK is connected to eight gate lines GTL1 to GTL8 and three bit lines BL1, BL2, and BL3, but is not limited thereto.

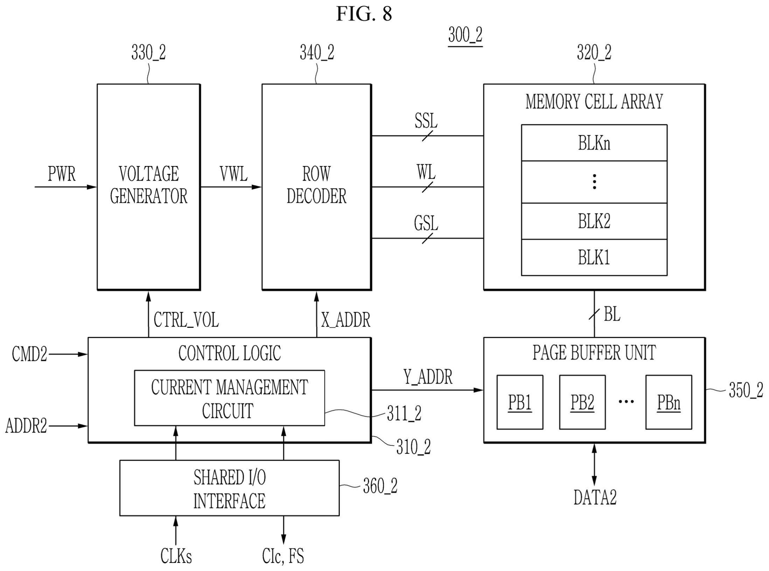

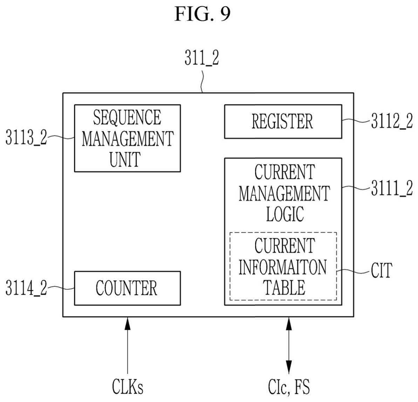

FIG. 8 is a block diagram of a non-volatile memory device according to one or more embodiments. FIG. 9 is a block diagram illustrating a current management circuit according to one or more embodiments. Specifically, FIG. 8 illustrates configurations of the second non-volatile memory device 300_2 (refer to FIG. 2) that receives the shared clock signal CLKs via the shared clock line Lsc (refer to FIG. 2), and FIG. 9 illustrates a current management circuit within the second non-volatile memory device 300_2 (refer to FIG. 2). It should be understood that the description of the second non-volatile memory device 300_2 of FIG. 2 may be applied to the third and fourth non-volatile memory devices 300_3 and 300_4 (refer to FIG. 2), which will be described hereinafter.

Referring to FIG. 8 and FIG. 9, the second non-volatile memory device 300_2 may include a second control logic circuit 310_2, a second memory cell array 320_2, a second page buffer unit 350_2, a second voltage generator 330_2, a second row decoder 340_2, and a second shared input/output interface circuit 360_2. In addition, the second control logic circuit 310_2 may include a second current management circuit 311_2.

The second control logic circuit 310_2, the second current management circuit 311_2, the second memory cell array 320_2, the second page buffer unit 350_2, the second voltage generator 330_2, the second row decoder 340_2, and the second shared input/output interface circuit 360_2 may each correspond to the first control logic circuit 310_1, the first current management circuit 311_1, the first memory cell array 320_1, the first page buffer unit 350_1, the first voltage generator 330_1, the first row decoder 340_1, and the first shared input/output interface circuit 360_1 of FIG. 4 to FIG. 7.

For convenience in description hereinafter, the second control logic circuit 310_2, the second current management circuit 311_2, the second memory cell array 320_2, the second page buffer unit 350_2, the second voltage generator 330_2, the second row decoder 340_2, and the second shared input/output interface circuit 360_2 will be described, focusing on differences with the first control logic circuit 310_1, the first current management circuit 311_1, the first memory cell array 320_1, the first page buffer unit 350_1, the first voltage generator 330_1, the first row decoder 340_1, and the first shared input/output interface circuit 360_1 of FIG. 4 to FIG. 7.

The second control logic circuit 310_2 may output various control signals in response to the second command CMD2 and/or second address ADDR2 from the memory interface circuit 260 of FIG. 3.

The second current management circuit 311_2 may receive the shared clock signal CLKs on the shared clock line Lsc and transmit and/or receive the flag signal FS and the current information code CIc on the shared data line Lc through the second shared input/output interface circuit 360_2. Specifically, the second current management circuit 311_2 may output the second flag signal FS2 and the second current information code CIc2 to the shared data line Lc, and receive the first flag signal FS1 and the third and fourth flag signals FS3 and FS4, the first current information code CIc1, and the third and fourth current information codes CIc3 and CIc4 through the shared data line Lc.

The second current management circuit 311_2 may output the second flag signal FS2 during the flag period before the memory operation of the second non-volatile memory device 300_2 is performed, and in response to the output of the second flag signal FS2, may output the second current information code CIc2 for the memory operation during the data output period following the flag period. That is, the second current management circuit 311_2 may output the second flag signal FS2 as a reservation signal in the preceding flag period before outputting the second current information code CIc2 for the memory operation in the data output period.

The second current management circuit 311_2 may receive at least some of the first flag signal FS1 and the third to fourth flag signals FS3 and FS4 during the flag period, and may receive a current information code from a non-volatile memory device that outputs a flag signal during the data output period following the flag period.

The second current management circuit 311_2 may determine whether to delay a memory operation scheduled to be performed by the second non-volatile memory device 300_2 based on the current information code received from the preceding non-volatile memory device and the output second current information code CIc2. The second current management circuit 311_2 may control other components within the second non-volatile memory device 300_2 to delay the memory operation of the second non-volatile memory device 300_2.

The second current management circuit 311_2 may include a second current management logic 3111_2, a second register 3112_2, a second sequence manager 3113_2, and a second counter 3114_2. The second current management logic 3111_2, the second register 3112_2, the second management logic 3113_2, and the second counter 3114_2 may respectively correspond to the first current management logic 3111_1, the first register 3112_1, the first sequence management unit 3113_1, and the first counter 3114_1 of FIG. 6, and for convenience in description hereinafter, the second current management circuit 311_2 will be described, focusing on the differences with the first current management circuit 311_1.

Unlike the first current management logic 3111_1 of FIG. 4 to FIG. 7, the second current management circuit 311_2 may not include a clock generator. Accordingly, the second counter 3114_2 of the second current management circuit 311_2 may count a clock cycle of the shared clock signal CLKs received through the second shared input/output interface circuit 360_2.

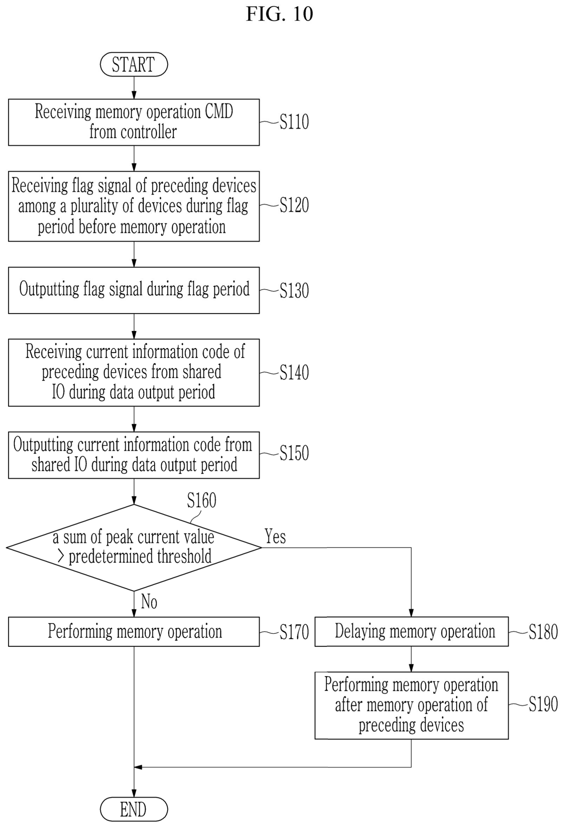

FIG. 10 is a flowchart of an operation method of a storage device according to one or more embodiments. Specifically, the flowchart of FIG. 10 illustrates the operation method of the storage device in one flag period and the data output period corresponding to and subsequent to the flag period.

Referring to FIG. 2, FIG. 4, FIG. 8, and FIG. 10, at least a part of the first non-volatile memory device 300_1 to the fourth non-volatile memory device 300_4 may receive commands CMD1 to CMD4 for the memory operation from the controller 200 (S110).

In some embodiments, the non-volatile memory device that received the command may output a wake-up signal on the shared data line Lc. The first non-volatile memory device 300_1 may receive the wake-up signal from the shared data line Lc, and based on the reception of the wake-up signal, may output the shared clock signal CLKs through the shared clock line Lsc and activate the flag period.

For example, the third non-volatile memory device 300_3 may receive the third command CMD3 for the memory operation from the controller 200, and output the wake-up signal to the shared data line Lc before performing the memory operation for the third command CMD3. The first non-volatile memory device 300_1 may receive the wake-up signal from the shared data line Lc, and output the shared clock signal CLKs through the shared clock line Lsc based on reception of the wake-up signal.

At least some of the first non-volatile memory device 300_1 to the fourth non-volatile memory device 300_4 may receive a flag signal of a preceding non-volatile memory device among the first non-volatile memory device 300_1 to the fourth non-volatile memory device 300_4 during the flag period before the memory operation (S120).

The first non-volatile memory device 300_1 to the fourth non-volatile memory device 300_4 may output the flag signal synchronized to a predetermined clock cycle during the flag period.

In the storage device 100 according to one or more embodiments, flag signals may be output in the sequence of the first to fourth flag signals FS1 to FS4 through the shared data line Lc during the flag period. For example, when the first non-volatile memory device 300_1 and the third non-volatile memory device 300_3 among the first non-volatile memory device 300_1 to the fourth non-volatile memory device 300_4 output the first flag signal FS1 and the third flag signal FS3 during one flag period, the flag signals may be output to the shared data line Lc in an order of the first flag signal FS1 to the third flag signal FS3 in synchronization with a specific clock cycle of the shared clock signal CLKs.

In the present disclosure, a "preceding non-volatile memory device" means a non-volatile memory device that outputs a flag signal in advance during the same flag period, and in an example, the first non-volatile memory device 300_1 may be referred to as a preceding non-volatile device of the third non-volatile memory device 300_3.

For example, the third non-volatile memory device 300_3 may receive the first flag signal FS1 of the first non-volatile memory device 300_1, which is a preceding non-volatile device, during the flag period. In the example, the first non-volatile memory device 300_1 may have no preceding non-volatile device.

At least some of the first non-volatile memory device 300_1 to the fourth non-volatile memory device 300_4 output a flag signal during the flag period before the memory operation (S130).

For example, when the first non-volatile memory device 300_1 and the third non-volatile memory device 300_3 among the first non-volatile memory device 300_1 to the fourth non-volatile memory device 300_4 output the first flag signal FS1 and the third flag signal FS3 during one flag period, the third non-volatile memory device 300_3 may output the third flag signal FS3 on the shared data line Lc in synchronization with a specific clock cycle of the shared clock signal CLKs after the output of the first flag signal FS1.

Through S120 and S130, the first non-volatile memory device 300_1 to the fourth non-volatile memory device 300_4 may share a flag signal output during one flag period.

Each current management circuit in the first non-volatile memory device 300_1 to the fourth non-volatile memory device 300_4 may determine the order of the current information code during the data output period based on the flag signal output during one flag period. In some embodiments, the order of current information codes of the plurality of non-volatile memory devices 300_1 to 300_4 during the data output period may match an output order of flag signals during one flag period corresponding to the data output period.

For example, when the first non-volatile memory device 300_1 and the third non-volatile memory device 300_3 among the first non-volatile memory device 300_1 to the fourth non-volatile memory device 300_4 output flag signals FS1 and FS3 in that order during one flag period, first non-volatile memory device 300_1 and the third non-volatile memory device 300_3 may output current information codes CIc1 and CIc3 in that order during the data output period corresponding to the one flag period. In the above example, since the second non-volatile memory device 300_2 does not output the current information code during the data output period, the third non-volatile memory device 300_3 may output the third current information code CIc3 before the second non-volatile memory device 300_2 does.

At least some of the first non-volatile memory device 300_1 to the fourth non-volatile memory device 300_4 receive the current information code of the preceding non-volatile memory device from the shared data line Lc during the data output period corresponding to the flag period (S140).

The first non-volatile memory device 300_1 to the fourth non-volatile memory device 300_4 may output the current information code based on the output order of the flag signals in the corresponding flag period during the data output period.

For example, when the first non-volatile memory device 300_1 and the third non-volatile memory device 300_3 among the first non-volatile memory device 300_1 to the fourth non-volatile memory device 300_4 output flag signals, in the order of the first flag signal FS1 to the third flag signal FS3, during one flag period, the first non-volatile memory device 300_1 and the third non-volatile memory device 300_3 may output current information codes, in an order of the first current information code Clc1 to the third current information code CIc3, during the data output period corresponding to the one flag period. In the above example, during the data output period, the second non-volatile memory device 300_2 does not perform output of the current information code, and therefore the third non-volatile memory device 300_3 may output the third current information code CIc3 before the second non-volatile memory device 300_2 does.

In the present disclosure, a "preceding non-volatile memory device" means a non-volatile memory device that precedes and outputs the current information code during the same data output period, and in the example, the first non-volatile memory device 300_1 may be referred to as a preceding non-volatile device of the third non-volatile memory device 300_3.

For example, the third non-volatile memory device 300_3 may receive the first current information code CIc1 of the first non-volatile memory device 300_1, which is a preceding non-volatile device, during the data output period. In the example, the first non-volatile memory device 300_1 may have no preceding non-volatile device.

At least some of the first non-volatile memory device 300_1 to the fourth non-volatile memory device 300_4 output the current information code on the shared data line Lc during the data output period corresponding to the flag period (S150).

For example, among the first non-volatile memory device 300_1 to the fourth non-volatile memory device 300_4, the first non-volatile memory device 300_1 and the third non-volatile memory device 300_3 output flag signals in the order of the first and third flag signals FS1 and FS3 during one flag period and output the first current information code CIc1 during the corresponding data output period. Then, during the same data output period, the third non-volatile memory device 300_3 may output the third current information code CIc3 in synchronization with the shared clock signal CLKs on the shared data line Lc.

Through S140 and S150, the first non-volatile memory device 300_1 to the fourth non-volatile memory device 300_4 may share a data output code output during one data output period.

Each current management circuit within the first non-volatile memory device 300_1 to the fourth non-volatile memory device 300_4 may obtain a peak current sum for a peak current value based on the current information code of the preceding non-volatile memory device and the current information code of the non-volatile memory device output to the shared data line Lc.

At least some of the first non-volatile memory device 300_1 to the fourth non-volatile memory device 300_4 compare a peak current sum of a peak current value corresponding to a current information code of a preceding non-volatile memory device and a peak current value corresponding to an output current information code with a predetermined threshold value (S160).

In some embodiments, the predetermined threshold value may include information about the electric power budget. Prior to S110, the electric power budget may be provided from the controller 200 to the first non-volatile memory device 300_1 to the fourth non-volatile memory device 300_4, or may be predetermined. The power management circuit of the first non-volatile memory device 300_1 to the fourth non-volatile memory device 300_4 may compare the peak current sum with the electric power budget to determine whether to delay the memory operation of the corresponding non-volatile memory device.

For example, when the first non-volatile memory device 300_1 and the third non-volatile memory device 300_3 among the first non-volatile memory device 300_1 to the fourth non-volatile memory device 300_4 output current information codes in the order of the first current information code CIc1 to the third current information code CIc3 during the data output period, the first non-volatile memory device 300_1 may compare the peak current value corresponding to the first current information code CIc1 with the electric power budget. The third non-volatile memory device 300_3 may compare the peak current sum of the peak current value corresponding to the third current information code CIc3 and the peak current value corresponding to the first current information code CIc1, which is the preceding non-volatile memory device 300_1, with the electric power budget.

In some embodiments, at least some of the first non-volatile memory device 300_1 to the fourth non-volatile memory device 300_4 may compare a peak current value corresponding to the current information code of the preceding non-volatile memory device with a predetermined threshold value. When the sum of the peak current values with respect to the preceding non-volatile memory device (that is, the sum of the peak current value for the preceding non-volatile memory device and the peak current value for a corresponding non-volatile memory device among the first to the fourth non-volatile memory devices 300_1 to 300_4) is greater than the predetermined threshold value, at least some of the first non-volatile memory device 300_1 to the fourth non-volatile memory device 300_4 may determine whether to delay the memory operation of the corresponding non-volatile memory device before outputting the current information code.

At least some of the first non-volatile memory device 300_1 to the fourth non-volatile memory device 300_4 perform the memory operation without a delay when the sum of peak currents is not greater than the predetermined threshold value (S170).

At least some of the first non-volatile memory device 300_1 to the fourth non-volatile memory device 300_4 delay the memory operation when the sum of the peak current values is greater than the predetermined threshold value (S180).

In some embodiments, a current information code of a preceding non-volatile memory device may be compared with its electric power budget to delay an output of a current information code and a memory operation of the corresponding device. For example, when the sum of the peak current values with respect to the preceding non-volatile memory device is greater than the predetermined threshold value, at least some of the first non-volatile memory device 300_1 to the fourth non-volatile memory device 300_4 may delay the memory operation and delay outputting the current information code.

At least some of the first non-volatile memory device 300_1 to the fourth non-volatile memory device 300_4 perform the memory operation after the memory operation of the preceding non-volatile memory device (S190).

For example, when the peak current sum of the peak current value corresponding to the first current information code CIc1 and the peak current value corresponding to the third current information code CIc3 is greater than the electric power budget, the memory operation for the third non-volatile memory device 300_3 may be performed after the memory operation for the first non-volatile memory device 300_1.

According to one or more embodiments, the storage device 100 may avoid an overlap between peak power periods without a need for arranging a complex dedicated circuit in the controller 100 through the shared input/output line IOs connecting the plurality of non-volatile memory devices 300_1 to 300_4 and the current management circuits that are individually disposed in the plurality of non-volatile memory devices 300_1 to 300_4 and operate under the same condition.

The storage device 100 according to one or more embodiments may increase the occupation efficiency of the shared input/output line IOs by outputting only current information codes requiring overlap confirmation to a shared input/output line IOs through a flag signal, which is a reservation signal for current information codes output in a flag period.

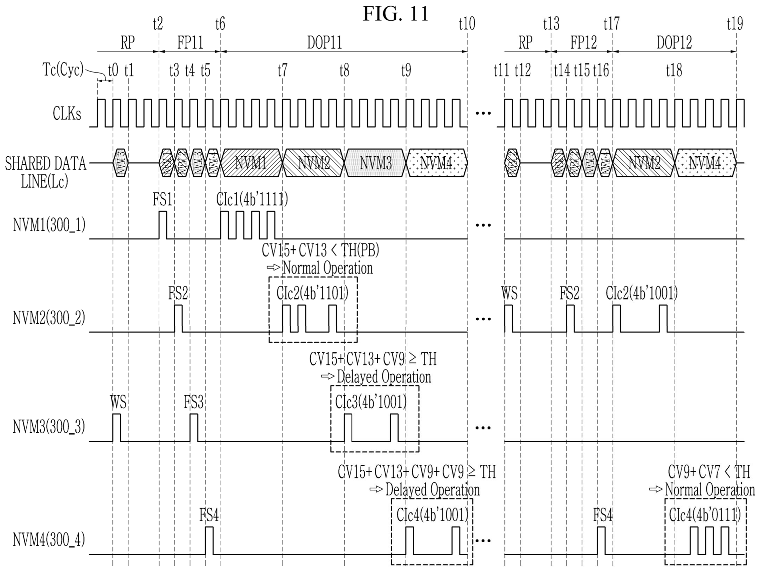

FIG. 11 is a timing diagram illustrating an operation method of the storage device according to one or more embodiments.

Referring to FIG. 2, FIG. 6, and FIG. 11, before t0, the third non-volatile memory device 300_3 may receive a third command CMD3 for a memory operation from the controller 100. In some embodiments, a time period preceding the reception of the third command CMD3 may be an idle period RP of the shared input/output line IOs, during which no valid signal transmission may occur on the shared input/output line IOs.

The plurality of non-volatile memory devices 300_1 to 300_4 within the storage device 100 may output a signal in an active high manner to a shared data line Lc by synchronizing with a clock cycle Cyc corresponding to a clock period Tc of a shared clock signal CLKs as a reference. In the present disclosure, In some embodiments, a signal input/output to the shared data line Lc may be encoded in various ways, and may be output in the active high manner as described above. The encoding method may include return to zero (RZ), non-return to zero (NRZ), Manchester code, and the like. For example, the first non-volatile memory device 300_1 may output a code encoded in the RZ mode in an active high manner, and the second non-volatile memory devices 300_2 to the fourth non-volatile memory device 300_4 may receive information by decoding a code output from the first non-volatile memory device 300_1 in the RZ manner

Between t0 and t1, in response to receiving the third command CMD3, the third non-volatile memory device 300_3 may output a wake-up signal WS to the shared data line Lc, and the remaining non-volatile memory devices 300_1, 300_2, and 300_4 may receive the wake-up signal WS. In FIG. 11, the third non-volatile memory device 300_3 is illustrated as outputting the wake-up signal WS in synchronization with a rising edge of the shared clock signal CLKs, but is not limited thereto, and, In some embodiments, the shared clock signal CLKs may not be output at t0.

At t2, the first non-volatile memory device 300_1 may activate a 1_1 flag period FP11 in response to receiving the wake-up signal WS. In some embodiments, the first non-volatile memory device 300_1 may, as a master device, output the shared clock signal CLKs with the 1_1 flag period FP11 enabled.

In the 1_1 flag period FP11, the plurality of non-volatile memory devices 300_1 to 300_4 may output 1-bit flag signals FS1 to FS4, which are respective reservation signals for the current information codes CIc1 to CIc4, on the shared data line Lc, synchronized to a predetermined clock cycle. In some embodiments, the 1_1 flag period FP11 may have a fixed time interval, and may include at least four clock cycles Cyc.

In some embodiments, a time interval of the 1_1 flag period FP11 and a 1_2 flag period FP12 may vary depending on the number of non-volatile memory devices connected to the shared input/output line IOs. For example, when the number of non-volatile memory devices connected to the shared input/output line IOs is four, a time interval of each of the flag periods FP11 and FP12 may be longer than at least four clock cycles Cyc.

The plurality of non-volatile memory devices 300_1 to 300_4 may each output a flag signal as a unit of one clock cycle Cyc in the order of the first to fourth flag signals FS1 to FS4 based on a count value of the counter 3114.

As an example, referring to FIG. 11, at t2, which is a time point in the 1_1 flag period FP11, the first non-volatile memory device 300_1 may output a first flag signal FS1 having at least one clock cycle Cyc, the second non-volatile memory device 300_2 may output a second flag signal FS2 having at least one clock cycle Cyc at t3, the third non-volatile memory device 300_3 may output a third flag signal FS3 having at least one clock cycle Cyc at t4, and the fourth non-volatile memory device 300_4 may output a fourth flag signal FS4 having at least one clock cycle Cyc at t5.

Each of the plurality of non-volatile memory devices 300_1 to 300_4 may determine the order of current information codes CIc1 to CIc4 in a 1_1 data output period DOP11 corresponding to the 1_1 flag period FP11, based on the output of the first to fourth flag signals FS1 to FS4 in the 1_1 flag period FP11.

As an example, referring to FIG. 11, with the 1_1 flag period FP11 as a reference, in the 1_1 data output period DOP11, the first non-volatile memory device 300_1 may be the preceding non-volatile memory device of the second to fourth non-volatile memory devices 300_2 to 300_4. With the 1_1 flag period FP11 as a reference, in the 1_1 data output period DOP11, the second non-volatile memory device 300_2 may be the preceding non-volatile memory device of the third to fourth non-volatile memory devices 300_3 to 300_4. With the 1_1 flag period FP11 as a reference, in the 1_1 data output period DOP11, the third non-volatile memory device 300_3 may be the preceding non-volatile memory device of the fourth non-volatile memory device 300_4.

In the 1_1 data output period DOP11, the plurality of non-volatile memory devices 300_1 to 300_4 may output 4-bit current information codes in the order of first to fourth current information codes CIc1 to CIc4 with the 1_1 flag period FP11 as a reference.

The plurality of non-volatile memory devices 300_1 to 300_4 may each output a current information code as a unit of four clock cycles Cyc in the order of the first to fourth current information codes CIc1 to CIc4 based on the count value of the counter 3114.

As an example, referring to FIG. 11, the first non-volatile memory device 300_1 may preferentially output the first current information code CIc1 having at least four clock cycles Cyc at t6, which is a time point of the 1_1 data output period DOP11, the second non-volatile memory device 300_2 may output the second current information code CIc2 with at least four clock cycles Cyc at t7, the third non-volatile memory device 300_3 may output the third current information code CIc3 with at least four clock cycles Cyc at t8, and the fourth non-volatile memory device 300_4 may output the fourth current information code CIc4 with at least four clock cycles Cyc at t9.

As an example, referring to FIG. 11, the first current information code CIc1 in the 1_1 data output period DOP11 may be 4b'1111, and may correspond to a fifteenth memory operation OP15 with the current information table CIT of FIG. 6 as a reference. In the 1_1 In data output period DOP11, the second current information code CIc2 may be 4b'1101 and may correspond to a thirteenth memory operation OP13 with the current information table CIT as a reference. In the 1_1 In data output period DOP11, the third current information code CIc3 may be 4b'1001 and may correspond to a ninth memory operation OP9 with the current information table CIT as a reference. In the 1_1 In data output period DOP11, the fourth current information code CIc4 may be 4b'1001 and may correspond to the ninth memory operation OP9 with the current information table CIT as a reference.

After that, the first non-volatile memory device 300_1 may compare a fifteenth peak current value CV15, corresponding to the fifteenth memory operation OP15, with a threshold value TH corresponding to the electric power budget, and determine delay for the fifteenth memory operation OP15. As an example, referring to FIG. 11, the first non-volatile memory device 300_1 may perform a normal operation of the fifteenth memory operation OP15 without a delay. In some embodiments, the threshold value TH may be fixed to a predetermined value or may vary depending on the electric power budget received from the controller 200.

After that, the second non-volatile memory device 300_2 may obtain a peak current sum by adding the fifteenth peak current value CV15 corresponding to the preceding non-volatile memory device (that is, the first non-volatile memory device 300_1) and the thirteenth peak current value CV13 corresponding to the second non-volatile memory device 300_2, and compare the obtained peak current sum with the threshold value TH to determine whether to delay the thirteenth memory operation OP13 of the second non-volatile memory device 300_2. As an example, referring to FIG. 11, based on a result of the comparison, the second non-volatile memory device 300_2 may perform a normal operation of the thirteenth memory operation OP13 without a delay.

After that, the third non-volatile memory device 300_3 may obtain the peak current sum by adding the fifteenth peak current value CV15 and the thirteenth peak current value CV13, corresponding to the preceding non-volatile memory device, and the ninth peak current value CV9 corresponding to the third non-volatile memory device 300_3, and compare the obtained peak current sum with the threshold value TH to determine whether to delay the thirteenth memory operation OP13. As an example, referring to FIG. 11, based on a result of the comparison, the third non-volatile memory device 300_3 may perform the ninth memory operation OP9 by delaying the ninth memory operation OP9.

After that, the fourth non-volatile memory device 300_4 may obtain the peak current sum by adding the fifteenth peak current value CV15, the thirteenth peak current value CV13, and the ninth peak current value CV9, corresponding to the preceding non-volatile memory device, and the ninth peak current value CV9 corresponding to the fourth non-volatile memory device 300_4, and compare the obtained peak current sum with the threshold value TH to determine whether to delay the ninth memory operation OP9. As an example, referring to FIG. 11, based on a result of the comparison, the fourth non-volatile memory device 300_4 may perform the ninth memory operation OP9 by delaying the ninth memory operation OP9.

At t10 and t11, the second non-volatile memory device 300_2 may receive the second command CMD2 for the memory operation from the controller 100. In some embodiments, a time period prior to the reception of the second command CMD2 may be the idle period RP of the shared input/output line IOs, during which no valid signal transmission may occur on the shared input/output line IOs.

Between t11 and t12, in response to the reception of the second command CMD2, the second non-volatile memory device 300_2 may output the wake-up signal WS to the shared data line Lc, and the remaining non-volatile memory devices 300_1, 300_3, and 300_4 may receive the wake-up signal WS.

At t13, the first non-volatile memory device 300_1 may activate the 1_2 flag period FP12 in response to receiving the wake-up signal WS. In some embodiments, the first non-volatile memory device 300_1, as a master device, may output the shared clock signal CLKs while activating the 1_2 flag period FP12.

In the 1_2 flag period FP12, at least some of the plurality of non-volatile memory devices 300_1 to 300_4 may output at least some of the 1-bit flag signals FS1 to FS4, which are respective reservation signals for the current information codes CIc1 to CIc4, on the shared data line Lc in synchronization with a predetermined clock cycle. In some embodiments, the 1_2 flag period FP12 may have a fixed time interval, which may include at least four clock cycles Cyc. In some embodiments, a time interval of each of the flag periods FP11 and FP12 may vary depending on the number of non-volatile memory devices connected to the shared input/output line IOs.

The plurality of non-volatile memory devices 300_1 to 300_4 may each output a flag signal as a unit of one clock cycle Cyc in the order of the first to fourth flag signals FS1 to FS4 based on a count value of the counter 3114.

As an example, referring to FIG. 11, the second non-volatile memory device 300_2 may output the second flag signal FS2 having at least one clock cycle Cyc at t14, and the fourth non-volatile memory device 300_4 may output the fourth flag signal FS4 having at least one clock cycle Cyc at t16. At t13 and t15, the first flag signal FS1 and the third flag signal FS3 may not be output.

The current management circuit within the plurality of non-volatile memory devices 300_1 to 300_4 may determine the order of the second and fourth current information codes CIc2 and CIc4, which is an output order in a 1_2 data output period DOP12, based on the output order of the second and fourth flag signals FS2 and FS4 in the 1_2 flag period FP12.

As an example, referring to FIG. 11, with reference to the 1_2 flag period FP12, the second non-volatile memory device 300_2 may be a preceding non-volatile memory device of the fourth non-volatile memory device 300_4 in the 1_2 data output period DOP12.

In the 1_2 data output period DOP12, the second non-volatile memory device 300_2 and the fourth non-volatile memory device 300_4 may output 4-bit current information codes in the order of the second current information code Clc2 to the fourth current information code CIc4, with the 1_2 flag period FP12 as a reference.

Each of the second non-volatile memory device 300_2 and the fourth non-volatile memory device 300_4 may output a current information code as a unit of four clock cycles Cyc in the order of the second current information code Clc2 to the fourth current information code CIc4, based on the count value of the counter 3114.

Since the first non-volatile memory device 300_1 does not output a current information code during the 1_2 data output period DOP12, the second non-volatile memory device 300_2 and the fourth non-volatile memory device300_4 may output the second and fourth current information codes CIc2 and CIc4 before the first non-volatile memory device 300_1 does. Similarly, since the third non-volatile memory device 300_3 does not output a current information code during the 1_2 data output period DOP12, the fourth non-volatile memory device 300_4 may output the fourth current information code CIc4 before the third non-volatile memory device 300_3 does.

As an example, referring to FIG. 11, at t17, which is a time point in the 1_2 data output period DOP12, the second non-volatile memory device 300_2 may preferentially output the second current information code CIc2 having at least four clock cycles Cyc, and the fourth non-volatile memory device 300_4 may continuously output the fourth current information code CIc4 having at least four clock cycles Cyc at t18.

As an example, referring to FIG. 11, the second current information code CIc2 in the 1_2 data output period DOP12 may be 4b'1001 and may correspond to the ninth memory operation OP9 with reference to the current information table CIT of FIG. 6. In the 1_2 data output period DOP12, the fourth current information code CIc4 may be 4b'0111 and may correspond to the seventh memory operation OP7 with the current information table CIT as a reference.

After that, the second non-volatile memory device 300_2 may compare the ninth peak current value CV9 corresponding to the second non-volatile memory device 300_2 with the threshold value TH corresponding to the electric power budget PB, and determine whether to delay the ninth memory operation OP9. As an example, referring to FIG. 11, based on a result of the comparison, the second non-volatile memory device 300_2 may perform the ninth memory operation OP9 normally without a delay.

After that, the fourth non-volatile memory device 300_4 may obtain the peat current sum by adding the ninth peak current value CV9 corresponding to the preceding non-volatile memory device, and the seventh peak current value CV7 corresponding to the fourth non-volatile memory device 300_4, and compare the obtained peak current sum with the threshold value TH to determine whether to delay the seventh memory operation OP7. As an example, referring to FIG. 11, based on a result of the comparison, the fourth non-volatile memory device 300_4 may normally perform the seventh memory operation OP7 without a delay.

The storage device 100 according to one or more embodiments may efficiently output a current information code to a shared data line Lc by reducing unnecessary output of the current information code through the output of a flag signal, which is a reservation signal for the current information code.

The storage device 100 according to one or more embodiments may deactivate the shared input/output line IOs when no input/output of the shared input/output line IOs through the flag period is required. The storage device 100 according to one or more embodiments may improve power efficiency and operational efficiency for the shared input/output line IOs by efficiently activating a flag period and a data output period of a current information code when input/output of the shared input/output line IOs is required.

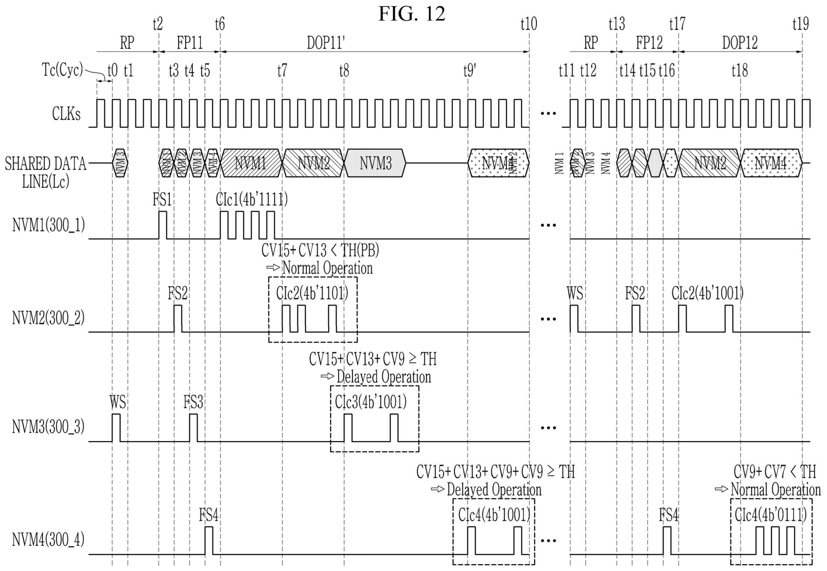

FIG. 12 is a timing diagram illustrating an operation method of the storage device according to one or more embodiments. The timing diagram of FIG. 12 may correspond to the timing diagram of FIG. 11, and flag periods FP11 and FP12 and data output periods DOP11' and DOP12 of FIG. 12 may correspond to the flag periods FP11 and FP12 and the data output periods DOP11 and DOP12 of FIG. 11. Hereinafter, for ease of description, the flag periods FP11 and FP12 and the data output periods DOP11' and DOP12 of FIG. 12 will be described with a focus on differences with the flag periods FP11 and FP12 and the data output periods DOP11 and DOP12 of FIG. 11.

Referring to FIG. 2, FIG. 6, and FIG. 12, at time t6, which is a time point of the 1_1 data output period DOP11', the first non-volatile memory device 300_1 may preferentially output the first current information code CIc1 having at least four clock cycles Cyc, the second non-volatile memory device 300_2 may output the second current information code CIc2 having at least four clock cycles Cyc at t7, third non-volatile memory device 300_3 may output third current information code CIc3 having at least four clock cycles Cyc at t8, and the fourth non-volatile memory device 300_4 may output the fourth current information code CIc4 having at least four clock cycles Cyc with a delay at t9'.

As an example, referring to FIG. 12, at time t9', which is delayed by four clock cycles Cyc with reference to the output of the third current information code CIc3 (that is, delayed by four clock cycles Cyc compared to t9 in FIG. 11), the fourth non-volatile memory device 300_4 may output the fourth current information code CIc4. Although it is illustrated in FIG. 12 that the output of the fourth current information code CIc4 is delayed by four clock cycles Cyc, but a delay time interval may vary In some embodiments.

The fourth non-volatile memory device 300_4 may obtain the peak current sum by adding the fifteenth peak current value CV15, the thirteenth peak current value CV13, and the ninth peak current value CV9, corresponding to the preceding non-volatile memory device, and the ninth peak current value CV9 corresponding to the fourth non-volatile memory device 300_4, and compare the obtained peak current sum with the threshold value TH to determine whether to delay the ninth memory operation OP9. As an example, referring to FIG. 12, based on a result of the comparison, the fourth non-volatile memory device 300_4 may perform an operation by delaying the ninth memory operation OP9 and output the fourth current information code CIc4 by delaying the output.

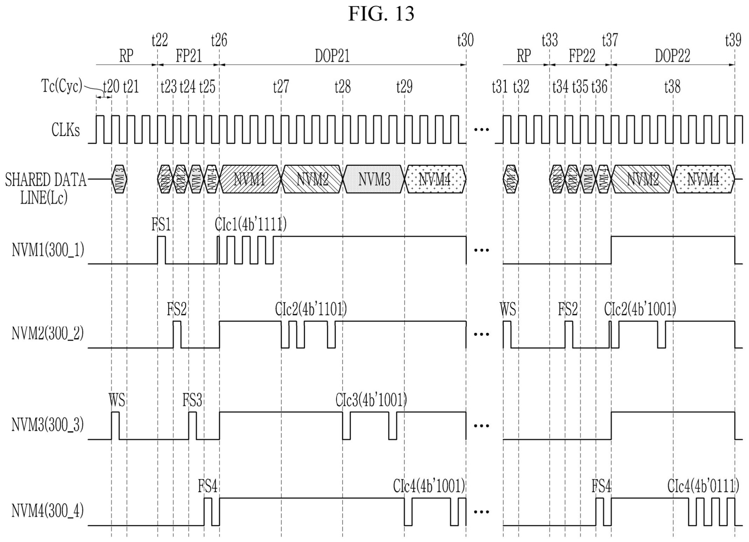

FIG. 13 is a timing diagram illustrating an operation method of the storage device according to one or more embodiments.

Referring to FIG. 2, FIG. 6, and FIG. 13, before t20, the third non-volatile memory device 300_3 may receive the third command CMD3 for the memory operation from the controller 100.

The plurality of non-volatile memory devices 300_1 to 300_4 within the storage device 100 may output a signal on the shared data line Lc in an active high manner in synchronization with a specific clock cycle Cyc during flag periods FP21 and FP22. The plurality of non-volatile memory devices 300_1 to 300_4 within the storage device 100 may output a signal in an active low manner to the shared data line Lc in synchronization with the clock cycle Cyc during data output periods DOP21 and DOP22.

Between t20 and t21, in response to receiving the third command CMD3, the third non-volatile memory device 300_3 may output the wake-up signal WS to the shared data line Lc, and the remaining non-volatile memory devices 300_1, 300_2, and 300_4 may receive the wake-up signal WS.

At t22, the first non-volatile memory device 300_1 may activate a 2_1 flag period FP21 in response to the reception of the wake-up signal WS. In some embodiments, the first non-volatile memory device 300_1, as a master device, may output the shared clock signal CLKs while activating the 2_1 flag period FP21.

In the 2_1 flag period FP21, the plurality of non-volatile memory devices 300_1 to 300_4 may output 1-bit flag signals FS1 to FS4, which are respective reservation signals for the current information codes CIc1 to CIc4, on the shared data line Lc, synchronized to a predetermined clock cycle. In some embodiments, the 2_1 the flag period FP21 may have a fixed time interval and may include at least four clock cycles Cyc. In some embodiments, time intervals of the flag periods FP21 and FP22 may vary depending on the number of non-volatile memory devices connected to the shared input/output line IOs.

Each of the plurality of non-volatile memory devices 300_1 to 300_4 may output a flag signal as a unit of one clock cycle Cyc in the order of the first to fourth flag signals FS1 to FS4 based on the count value of the counter 3114.

As an example, referring to FIG. 13, at t22, which is a time point of the 2_1 flag period FP21, the first non-volatile memory device 300_1 may output the first flag signal FS1 having at least one clock cycle Cyc, the second non-volatile memory device 300_2 may output second flag signal FS2 having at least one clock cycle Cyc at t23, the third non-volatile memory device 300_3 may output the third flag signal FS3 having at least one clock cycle Cyc at t24, and the fourth non-volatile memory device 300_4 may output the fourth flag signal FS4 having at least one clock cycle Cyc at t25.

Each of the plurality of non-volatile memory devices 300_1 to 300_4 may determine the order of the current information codes CIc1 to CIc4 in the 2_1 data output period DOP21 corresponding to the 2_1 flag period FP21 based on the output of the first to fourth flag signals FS1 to FS4 in the 2_1 flag period FP21.

In the 2_1 data output period DOP21, the plurality of non-volatile memory devices 300_1 to 300_4 may output 4-bit current information codes in the order of the first to fourth current information codes CIc1 to CIc4 in an active low manner with the 2_1 flag period FP21 as a reference.

In some embodiments, during the 2_1 data output period DOP21, the shared data line Lc may be maintained at a high voltage as an inactive state in response to the first to fourth current information codes CIc1 to CIc4 being output on the shared data line Lc. In some embodiments, the shared data line Lc may maintain the inactive state through a pull-up resistor, a transistor, and the like.

Each of the plurality of non-volatile memory devices 300_1 to 300_4 may output a current information code as a unit of four clock cycles Cyc in the order of the first to fourth current information codes CIc1 to CIc4 based on the count value of the counter 3114.

As an example, referring to FIG. 13, at t26, which is a time point of the 2_1 data output period DOP21, the first non-volatile memory device 300_1 may preferentially output the first current information code CIc1, the second non-volatile memory device 300_2 may output the second current information code CIc2 at t27, the third non-volatile memory device 300_3 may output the third current information code CIc3 at t28, and the fourth non-volatile memory device 300_4 may output the fourth current information code CIc4 at t29.

At t26, the first non-volatile memory device 300_1 may output the first current information code CIc1 in an active low manner with at least four clock cycles Cyc, which is a starting point of the 2_1 data output period DOP21. In some embodiments, in the output of the first current information code CIc1, the shared data line Lc in the inactive state may be maintained at a high voltage through a pull-up resistor, a transistor, and the like.

At t27, the second non-volatile memory device 300_2 may output the second current information code CIc2 with at least four clock cycles Cyc in an active low manner. In some embodiments, in the output of the second current information code CIc2, the shared data line Lc in the inactive state may be maintained at a high voltage through a pull-up resistor, a transistor, and the like.

At t28, the third non-volatile memory device 300_3 may output the third current information code CIc3 with at least four clock cycles Cyc in an active low manner. In some embodiments, in the output of the third current information code CIc3, the shared data line Lc in the inactive state may be maintained at a high voltage through a pull-up resistor, a transistor, and the like.

At t29, the fourth non-volatile memory device 300_4 may output the fourth current information code CIc4 with at least four clock cycle Cyc in an active low manner. In some embodiments, in the output of the fourth current information code CIc4, the shared data line Lc in the inactive state may be maintained at a high voltage through a pull-up resistor, a transistor, and the like.

As an example, referring to FIG. 13, the first current information code CIc1 may be 4b' 1111 in the 2_1 data output period DOP21, and may correspond to the fifteenth memory operation OP15 with the current information table CIT of FIG. 6 as a reference. In the 2_1 data output period DOP21, the second current information code CIc2 may be 4b'1101 and may correspond to the thirteenth memory operation OP13 with the current information table CIT as a reference. In the 2_1 data output period DOP21, the third current information code CIc3 may be 4b'1001 and may correspond to the ninth memory operation OP9 with the current information table CIT as a reference. In the 2_1 data output period DOP21, the fourth current information code CIc4 may be 4b' 1001 and may correspond to the ninth memory operation OP with the current information table CIT as a reference.

At t30 and t31, the second non-volatile memory device 300_2 may receive the second command CMD2 for the memory operation from the controller 100. In some embodiments, a time period prior to the reception of the second command CMD2 may be the idle period RP of the shared input/output line IOs, during which no valid signal transmission may occur on the shared input/output line IOs.

Between t31 and t32, in response to receiving the second command CMD2, the second non-volatile memory device 300_2 may output the wake-up signal WS to the shared data line Lc, and the remaining non-volatile memory devices 300_1, 300_3, and 300_4 may receive the wake-up signal WS.

At t33, the first non-volatile memory device 300_1 may activate a 2_2 flag period FP22 in response to the reception of the wake-up signal WS. In some embodiments, the first non-volatile memory device 300_1, as a master device, may output the shared clock signal CLKs while activating the 2_2 flag period FP22.

In the 2_2 flag period FP22, at least some of the plurality of non-volatile memory devices 300_1 to 300_4 may output at least some of 1-bit flag signals FS1 to FS4, which are respective reservation signals for the current information codes CIc1 to CIc4, on the shared data line Lc, synchronized to a predetermined clock cycle. In some embodiments, the 2_2 flag period FP22 may have a fixed time interval, which may include at least four clock cycles Cyc. In some embodiments, a time interval of the flag periods FP21 and FP22 may vary depending on the number of non-volatile memory devices connected to the shared input/output line IOs.

The plurality of non-volatile memory devices 300_1 to 300_4 may each output a flag signal as a unit of one clock cycle Cyc in the order of the first to fourth flag signals FS1 to FS4 based on a count value of the counter 3114.

As an example, referring to FIG. 13, the second non-volatile memory device 300_2 may out the second flag signal FS2 having at least one of clock cycle Cyc at t34, and the fourth non-volatile memory device 300_4 may output the fourth flag signal FS4 having at least one clock cycle Cyc at t36. At t33 and t35, the first flag signal FS1 and the third flag signal FS3 may not be output.

Each of the plurality of non-volatile memory devices 300_1 to 300_4 may determine the order of the second and fourth current information codes CIc2 and CIc4, which is an output order in the 2_2 data output period DOP22, based on the output order of the second and fourth flag signals FS2 and FS4 in the 2_2 flag period FP22.

In the 2_2 data output period DOP22, the second non-volatile memory device 300_2 and the fourth non-volatile memory device 300_4 may output 4-bit current information codes in the order of the current information codes CIc2 and the fourth current information code CIc4, with the 2_2 flag period FP22 as a reference.

Each of the second non-volatile memory device 300_2 and the fourth non-volatile memory device 300_4 may output a current information code as a unit of four clock cycles Cyc in the order of the second current information code CIc2 to the fourth current information code CIc4, based on the count value of the counter 3114.

During the 2_2 data output period DOP22, the first non-volatile memory device 300_1 may not output a current information code, and therefore, the second non-volatile memory device 300_2 and the fourth non-volatile memory device 300_4 may output the second and fourth current information codes CIc2 and CIc4 before the first non-volatile memory device 300_1 does. Similarly, during the 2_2 data output period DOP22, the third non-volatile memory device 300_3 may not output a current information code, and thus the fourth non-volatile memory device 300_4 may output the fourth current information code CIc4 before the third non-volatile memory device 300_3 does.

During the 2_2 data output period DOP22, each of the second non-volatile memory device 300_2 and the fourth non-volatile memory device 300_4 may output a current information code in an active low manner. In some embodiments, during the 2_2 data output period DOP22, the shared data line Lc may be maintained at a high voltage as an inactive state in response to the second and fourth current information codes CIc2 and CIc4 being output on the shared data line Lc.

As an example, referring to FIG. 13, at t37, which is a time point of the 2_2 data output period DOP22, the second non-volatile memory device 300_2 may preferentially output the second current information code CIc2, and the fourth non-volatile memory device 300_4 may output the fourth current information code CIc4 at t38.

At t37, the second non-volatile memory device 300_2 may output the second current information code CIc2 having at least four clock cycle Cyc in an active low manner. In some embodiments, in the output of the second current information code CIc2, the shared data line Lc in an inactive state may maintain a high voltage through a pull-up resistor, a transistor, and the like.

At t38, the fourth non-volatile memory device 300_4 may output the fourth current information code CIc4 having at least four clock cycle Cyc in an active low manner. In some embodiments, in the output of the fourth current information code CIc4, the shared data line Lc in the inactive state may be maintained at a high voltage through a pull-up resistor, a transistor, and the like.

As an example, referring to FIG. 13, in the 2_2 data output period DOP22, the second current information code CIc2 may be 4b' 1001 and may correspond to the ninth memory operation OP9 with the current information table CIT of FIG. 6 as a reference. In the 2_2 data output period DOP22, the fourth current information code CIc4 may be 4b'0111 and may correspond to the seventh memory operation OP7 with the current information table CIT as a reference.

The storage device 100 according to one or more embodiments may easily distinguish between the flag periods FP21 and FP22 and the data output periods DOP21 and DOP22 by differentiating a data output method for shared input/output line IOs with reference to the flag periods FP21 and FP22 and the data output periods DOP21 and DOP22.

The storage device 100 according to one or more embodiments may efficiently output a current information code to a shared data line Lc by reducing an unnecessary output of the current information code through an output of a flag signal, which is a reservation signal for the current information code.

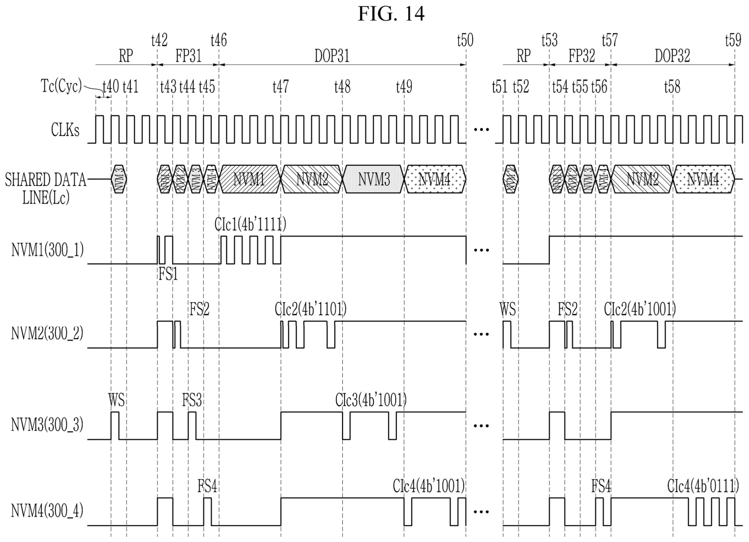

FIG. 14 is a timing diagram illustrating an operation method of the storage device according to one or more embodiments.

Referring to FIG. 2, FIG. 6, and FIG. 14, before t40, the third non-volatile memory device 300_3 may receive the third command CMD3 for the memory operation from the controller 100.

The first non-volatile memory device 300_1 may output a signal on the shared data line Lc in an active low manner, synchronized to a predetermined clock cycle Cyc, during flag periods FP31 and FP32. The first non-volatile memory device 300_1 may output a signal in an active high manner on the shared data line Lc in synchronization with the shared clock signal CLKs during data output periods DOP31 and DOP32.

The second non-volatile memory device 300_2 to the fourth non-volatile memory device 300_4 may output a signal on the shared data line Lc in an active high manner in synchronization with a predetermined clock cycle Cyc during the flag periods FP31 and FP32. The second non-volatile memory device 300_2 to the fourth non-volatile memory device 300_4 may output a signal on the shared data line Cl in an active low manner in synchronization with the shared clock signal CLKs during the data output periods DOP31 and DOP32.

Between t40 and t41, in response to the reception of the third command CMD3, the third non-volatile memory device 300_3 may output a wake-up signal WS to the shared data line Lc, and the remaining non-volatile memory devices 300_1, 300_2, and 300_4 may receive the wake-up signal WS.

At t42, the first non-volatile memory device 300_1 may activate a 3_1 flag period FP31 in response to receiving the wake-up signal WS. In some embodiments, the first non-volatile memory device 300_1, as a master device, may output the shared clock signal CLKs while activating the 3_1 flag period FP31.

In the 3_1 flag period FP31, the plurality of non-volatile memory devices 300_1 to 300_4 may output 1-bit flag signals FS1 to FS4, which are respective reservation signals for the current information codes CIc1 to CIc4, on the shared data line Lc, synchronized to a predetermined clock cycle. In some embodiments, the 3_1 flag period FP31 may have a fixed time interval and may include at least four clock cycles Cyc. In some embodiments, time intervals of the flag periods FP31 and FP32 may vary depending on the number of non-volatile memory devices connected to the shared input/output line IOs.

Each of the plurality of non-volatile memory devices 300_1 to 300_4 may output a flag signal as a unit of one clock cycle Cyc in the order of the first to fourth flag signals FS1 to FS4 based on the count value of the counter 3114.

As an example, referring to FIG. 14, at t42, which is a time point of the 3_1 flag period FP31, the first non-volatile memory device 300_1 may output the first flag signal FS1 having at least one clock cycle Cyc in an active low manner. In some embodiments, the shared data line Lc may be maintained at a high voltage as an inactive state through a pull-up resistor, a transistor, and the like in response to a clock cycle during which the first flag signal FS1 is output in the 3_1 flag period FP31.

The second non-volatile memory device 300_2 may output the second flag signal FS2 having at least one clock cycle Cyc in an active high manner at t43, the third non-volatile memory device 300_3 may output the third flag signal FS3 having at least one clock cycle Cyc in an active high manner at t44, and the fourth non-volatile memory device 300_4 may output the fourth flag signal FS4 having at least one clock cycle Cyc in an active high manner at t45. The shared data line Lc may be maintained at a low voltage as an inactive state in response to a clock cycle during which the second flag signal FS2 to the fourth flag signal FS4 are output in the 3_1 flag period FP31.

Each of the plurality of non-volatile memory devices 300_1 to 300_4 may determine the order of the current information codes CIc1 to CIc4 in a 3_1 data output period DOP31 corresponding to the 3_1 flag period FP31, based on the output of the first flag signals FS1 to the fourth flag signal FS4 in the 3_1 flag period FP31.

In the 3_1 data output period DOP31, the plurality of non-volatile memory devices 300_1 to 300_4 may output 4-bit current information codes in the order of the first to fourth current information codes CIc1 to CIc4 with the 3_1 flag period FP31 as a reference.

Each of the plurality of non-volatile memory devices 300_1 to 300_4 may output a current information code with a unit of four clock cycles Cyc in the order of the first to fourth current information codes CIc1 to CIc4 based on the count value of the counter 3114.

As an example, referring to FIG. 14, at t46, which is a time point of the 3_1 data output period DOP31, the first non-volatile memory device 300_1 may preferentially output the first current information code CIc1, and the second non-volatile memory device 300_2 may output the second current information code CIc2 at t47, the third non-volatile memory device 300_3 may output the third current information code CIc3 at t48, and the fourth non-volatile memory device 300_4 may output the fourth current information code CIc4 at t49.

At t46, the first non-volatile memory device 300_1 may output the first current information code CIc1 having at least four clock cycles Cyc in an active high manner. In some embodiments, the shared data line Lc may be maintained at a low voltage as an inactive state in response to the first current information code CIc1 being output on the shared data line Lc.

At t47, the second non-volatile memory device 300_2 may output the second current information code CIc2 having at least four clock cycles Cyc in an active low manner. In some embodiments, the shared data line Lc may be maintained at a high voltage as an inactive state through a pull-up resistor, a transistor, and the like in response to the second current information code CIc2 being output on the shared data line Lc.

At t48, the third non-volatile memory device 300_3 may output the third current information code CIc3 having at least four clock cycles Cyc in an active low manner. In some embodiments, the shared data line Lc may be maintained at a high voltage as an inactive state through a pull-up resistor, a transistor, and the like in response to the third current information code CIc3 being output on the shared data line Lc.

At t49, the fourth non-volatile memory device 300_4 may output the fourth current information code CIc4 having at least four clock cycles Cyc in an active low manner. In some embodiments, the shared data line Lc may be maintained at a high voltage as an inactive state through a pull-up resistor, a transistor, and the like in response to the third current information code CIc3 being output on the shared data line Lc.

As an example, referring to FIG. 14, in the 3_1 data output period DOP31, the first current information code CIc1 may be 4b'1111 and may correspond to the fifteenth memory operation OP15 with the current information table CIT of FIG. 6 as a reference. In the 3_1 data output period DOP31, the second current information code CIc2 may be 4b'1101 and may correspond to the thirteenth memory operation OP13 with the current information table CIT as a reference. In the 3_1 data output period DOP31, the third current information code CIc3 may be 4b'1001 and may correspond to the ninth memory operation OP9 with the current information table CIT as a reference. In the 3_1 data output period DOP31, the fourth current information code CIc4 may be 4b'1001 and may correspond to the ninth memory operation OP9 with the current information table CIT as a reference.

At t50 and t51, the second non-volatile memory device 300_2 may receive the second command CMD2 for the memory operation from the controller 100. In some embodiments, a time period prior to the reception of the second command CMD2 may be an idle period RP of a shared input/output line IOs, during which no valid signal transmission may occur on the shared input/output line IOs.

Between t51 and t52, in response to the reception of the second command CMD2, the second non-volatile memory device 300_2 may output a wake-up signal WS to the shared data line Lc and the remaining non-volatile memory devices 300_1, 300_3, and 300_4 may receive the wake-up signal WS.

At t53, the first non-volatile memory device 300_1 may activate a 3_2 flag period FP22 in response to the reception of the wake-up signal WS. In some embodiments, the first non-volatile memory device 300_1, as a master device, may output the shared clock signal CLKs while activating the 3_2 flag period FP32.

In the 3_2 flag period FP32, at least some of the plurality of non-volatile memory devices 300_1 to 300_4 may output at least some of 1-bit flag signals FS1 to FS4, which are respective reservation signals for the current information codes CIc1 to CIc4, on the shared data line Lc, synchronized to a predetermined clock cycle. In some embodiments, the 3_2 flag period FP32 may have a fixed time interval and may include at least four clock cycles Cyc. In some embodiments, the time intervals of the flag periods FP31 and FP32 may vary depending on the number of non-volatile memory devices connected to the shared input/output line IOs.

Each of the plurality of non-volatile memory devices 300_1 to 300_4 may output a flag signal as a unit of one clock cycle Cyc in the order of the first to fourth flag signals FS1 to FS4 based on the count value of the counter 3114.

As an example, referring to FIG. 14, the second non-volatile memory device 300_2 may output the second flag signal FS2 having at least one clock cycle Cyc in an active high manner at t54, and the fourth non-volatile memory device 300_4 may output fourth flag signal FS4 having at least one clock cycle Cyc in an active high manner at t56. The shared data line Lc may be maintained at a high voltage as an inactive state in response to a clock cycle during which the second flag signal FS2 and the fourth flag signal FS4 are output in the 3_2 flag period FP32.

At t53, the first flag signal FS1 may not be output and the shared data line Lc may be maintained at a high voltage as an inactive state. At t55, the third flag signal FS3 may not be output and the shared data line Lc may be maintained at a high voltage as an inactive state.

Each of the plurality of non-volatile memory devices 300_1 to 300_4 may determine the order of the second and fourth current information codes CIc2 and CIc4, which is an output order in the 3_2 data output period DOP32, based on the output order of the second and fourth flag signals FS2 and FS4 in the 3_2 flag period FP32.

In the 3_2 data output period DOP32, the second non-volatile memory device 300_2 and the fourth non-volatile memory device 300_4 may output 4-bit current information codes in the order of the second current information code CIc2 to the fourth current information code CIc4, with the 3_2 flag period FP32 as a reference.

Each of the second non-volatile memory device 300_2 and the fourth non-volatile memory device 300_4 may output a current information code as a unit of four clock cycles Cyc in the order of the second current information code CIc2 to the fourth current information code CIc4, based on the count value of the counter 3114.

During the 3_2 data output period DOP32, the first non-volatile memory device 300_1 may not output a current information code, and therefore, the second non-volatile memory device 300_2 and the fourth non-volatile memory device 300_4 may output the second and fourth current information codes CIc2 and CIc4 before the first non-volatile memory device 300_1 does. Similarly, during the 3_2 data output period DOP32, the third non-volatile memory device 300_3 may not output a current information code, and thus the fourth non-volatile memory device 300_4 may output the fourth current information code CIc4 before the third non-volatile memory device 300_3 does.

During the 3_2 data output period DOP32, each of the second non-volatile memory device 300_2 and the fourth non-volatile memory device 300_4 may output a current information code in an active low manner. In some embodiments, during the 3_2 data output period DOP32, the shared data line Lc may be maintained at a high voltage as an inactive state in response to the second and fourth current information codes CIc2 and CIc4 being output on the shared data line Lc.

As an example, referring to FIG. 14, at t57, which is a time point of the 3_2 data output period DOP32, the second non-volatile memory device 300_2 may preferentially output the second current information code CIc2, and the fourth non-volatile memory device 300_4 may output the fourth current information code CIc4 at t58.

At t57, the second non-volatile memory device 300_2 may output the second current information code CIc2 having at least four clock cycle Cyc in an active low manner. In some embodiments, the, shared data line Lc may be maintained at a high voltage as an inactive state through a pull-up resistor, a transistor, and the like in response to the second current information code CIc2 being output on the shared data line Lc.

At t58, the fourth non-volatile memory device 300_4 may output the fourth current information code CIc4 having at least four clock cycles Cyc in an active low manner. In some embodiments, the shared data line Lc may be maintained at a high voltage as an inactive state through a pull-up resistor, a transistor, and the like in response to the fourth current information code CIc4 being output on the shared data line Lc.

As an example, referring to FIG. 14, in the 3_2 data output period DOP32, the second current information code CIc2 may be 4b' 1001 and may correspond to the ninth memory operation OP9 with the current information table CIT of FIG. 6 as a reference. In the 3_2 data output period DOP32, the fourth current information code CIc4 may be 4b'0111 and may correspond to the seventh memory operation OP7 with the current information table CIT as a reference.

The storage device 100 according to one or more embodiments may easily distinguish between the flag periods FP31 and FP32 and the data output periods DOP31 and DOP32 by differentiating a data output method of the non-volatile memory device with reference to the flag periods FP31 and FP32 and the data output periods DOP31 and DOP32.

The storage device 100 according to one or more embodiments may efficiently output a current information code to a shared data line Lc by reducing an unnecessary output of the current information code through an output of a flag signal, which is a reservation signal for the current information code.

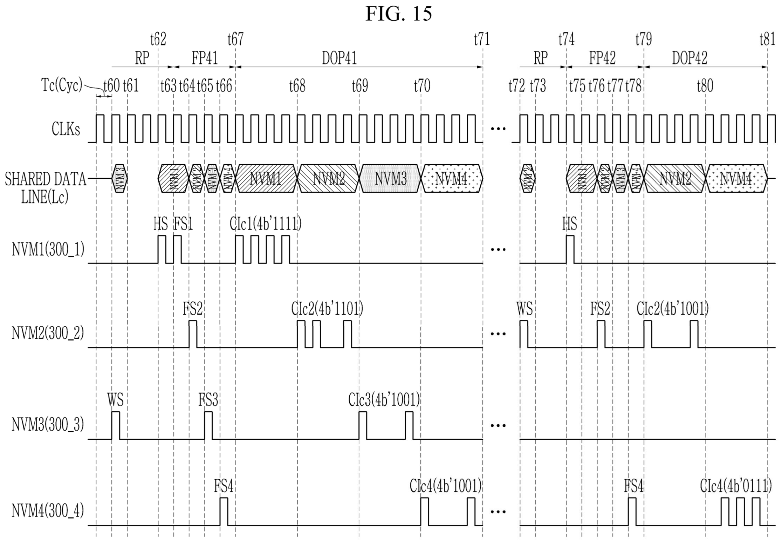

FIG. 15 is a timing diagram illustrating an operation method of the storage device according to one or more embodiments.

Referring to FIG. 2, FIG. 6, and FIG. 15, before t60, the third non-volatile memory device 300_3 may receive the third command CMD3 for the memory operation from the controller 100.

The plurality of non-volatile memory devices 300_1 to 300_4 within the storage device 100 may output a signal in an active high manner to the shared data line Lc by being synchronized with a clock cycle Cyc corresponding to the clock period Tc of the shared clock signal CLKs as a reference.

Between t60 and t61, in response to the reception of the third command CMD3, the third non-volatile memory device 300_3 may output a wake-up signal WS to the shared data line Lc, and the remaining non-volatile memory devices 300_1, 300_2, and 300_4 may receive the wake-up signal WS.

At t62, the first non-volatile memory device 300_1 may activate a 4_1 flag period FP41 in response to receiving the wake-up signal WS. In some embodiments, the first non-volatile memory device 300_1, as a master device, may output the shared clock signal CLKs while activating the 4_1 flag period FP41.

In the 4_1 flag period FP41, the first non-volatile memory device 300_1 may be synchronized by a predetermined clock cycle and may output a 1-bit header signal HS to the shared data line Lc, and the plurality of non-volatile memory devices 300_1 to 300_4 may be synchronized by the predetermined clock cycle and output 1-bit flag signals FS1 to FS4, which are respective reservation signals for the 1-bit current information codes CIc1 to CIc4 to the shared data line Lc. In some embodiments, the 4_1 flag period FP41 may have a fixed time interval, and may include at least five clock cycles Cyc. In some embodiments, time intervals of the 4_1 flag period FP41 and a 4_2 flag period FP42 may vary depending on the number of non-volatile memory devices connected to the shared input/output line IOs. In some embodiments, the header signal HS may further include measurement data such as remote measurement data.

The plurality of non-volatile memory devices 300_1 to 300_4 may output a signal with a unit of one clock cycle Cyc in the order of the header signal HS and the first to fourth flag signals FS1 to FS4 based on the count value of the counter 3114.

As an example, referring to FIG. 15, at t62, which is a time point of the 4_1 flag period FP41, the first non-volatile memory device 300_1 may output the header signal HS having at least one clock cycle Cyc, the first non-volatile memory device 300_1 may output the first flag signal FS1 having at least one clock cycle Cyc at t63, the second non-volatile memory device 300_2 may output the second flag signal FS2 having at least one clock cycle Cyc at t64, the third non-volatile memory device 300_3 may output the third flag signal FS3 having at least one clock cycle Cyc at t65, and the fourth non-volatile memory device 300_4 may output the fourth flag signal FS4 having at least one clock cycle Cyc at t66.

In FIG. 15, it is illustrated that the header signal HS is output during one clock cycle Cyc like the first to fourth flag signals FS1 to FS4, but In some embodiments, a time interval for the output of the header signal HS may vary. In some embodiments, a time interval for a signal output of the first non-volatile memory device 300_1 during the 4_1 flag period FP41 may be different from time intervals for signal outputs of the remaining non-volatile memory devices 300_2 to 300_4 during the 4_1 flag period FP41.

Although it is illustrated in FIG. 15 that the wake-up signal WS is output before the header signal HS is output, this is not restrictive, and In some embodiments, the wake-up signal WS may not be output before the header signal HS is output.

Each of the plurality of non-volatile memory devices 300_1 to 300_4 may determine the order of the current information codes CIc1 to CIc4 in a 4_1 data output period DOP41 corresponding to the 4_1 flag period FP41, based on the output of the first to fourth flag signals FS1 to FS4 in the 4_1 flag period FP41.

In the 4_1 data output period DOP41, the plurality of non-volatile memory devices 300_1 to 300_4 may output 4-bit current information codes in the order of the first to fourth current information codes CIc1 to CIc4 with the 4_1 flag period FP41 as a reference.

Each of the plurality of non-volatile memory devices 300_1 to 300_4 may output the current information code with a unit of four clock cycles Cyc in the order of the first to fourth current information codes CIc1 to CIc4 based on the counter value of the counter 3114.

As an example, referring to FIG. 15, at t67, which is a time point of the 4_1 data output period DOP1, the first non-volatile memory device 300_1 may preferentially output the first current information code CIc1 having at least four clock cycles Cyc, the second non-volatile memory device 300_2 may output the second current information code CIc2 having at least four clock cycles Cyc at t68, the third non-volatile memory device 300_3 may output the third current information code CIc3 having at least four clock cycles Cyc at t69, and the fourth non-volatile memory device 300_4 may output the fourth current information code CIc4 having at least four clock cycles Cyc at t70.

As an example, referring to FIG. 15, in the 4_1 data output period DOP41, the first current information code CIc1 may be 4b'1111 and may correspond to the fifteenth memory operation OP15 with the current information table CIT of FIG. 6 as a reference. In the 4_1 data output period DOP41, the second current information code CIc2 may be 4b'1101 and may correspond to the thirteenth memory operation OP13 with the current information table CIT as a reference. In the 4_1 data output period DOP41, the third current information code CIc3 may be 4b'1001 and may correspond to the ninth memory operation OP9 with the current information table CIT as a reference. In the 4_1 data output period DOP41, the fourth current information code CIc4 may be 4b' 1001 and may correspond to the ninth memory operation OP9 with the current information table CIT as a reference.

At t71 and t72, the second non-volatile memory device 300_2 may receive the second command CMD2 for the memory operation from the controller 100. In some embodiments, a time period prior to the reception of the second command CMD2 may be an idle period RP of a shared input/output line IOs, during which no valid signal transmission may occur on the shared input/output line IOs.

Between t72 and t73, in response to the reception of the second command CMD2, the second non-volatile memory device 300_2 may output a wake-up signal WS to the shared data line Lc and the remaining non-volatile memory devices 300_1, 300_3, and 300_4 may receive the wake-up signal WS.

At t74, the first non-volatile memory device 300_1 may activate the 4_2 flag period FP42 in response to the reception of the wake-up signal WS. In some embodiments, the first non-volatile memory device 300_1, as a master device, may output the shared clock signal CLKs while activating the 4_2 flag period FP42.

In the 4_2 flag period FP42, the first non-volatile memory device 300_1 may output the 1-bit header signal HS on the shared data line Lc in synchronization with a predetermined clock cycle, and at least some of the plurality of non-volatile memory devices 300_1 to 300_4 may output at least some of the 1-bit flag signals FS1 to FS4, which are respective reservation signals for the current information codes CIc1 to CIc4, in synchronization with a predetermined clock cycle, on the shared data line Lc. In some embodiments, the 4_2 flag period FP42 may have a fixed time interval and may include at least five clock cycles Cyc. In some embodiments, time intervals of the flag periods FP41 and FP42 may vary depending on the number of non-volatile memory devices connected to the shared input/output line IOs.

The plurality of non-volatile memory devices 300_1 to 300_4 may each output a signal with a unit of one clock cycle Cyc in the order of the header signal HS and the first to fourth flag signals FS1 to FS4 based on the count value of the counter 3114.

As an example, referring to FIG. 15, the second non-volatile memory device 300_2 may output the second flag signal FS2 having at least one clock cycle Cyc at t76, and the fourth non-volatile memory device 300_4 may output the fourth flag signal FS4 having at least one clock cycle Cyc at t78. At t75 and t77, the first flag signal FS1 and the third flag signal FS3 may not be output.

Each of the plurality of non-volatile memory devices 300_1 to 300_4 may determine the order of the second and fourth current information codes CIc2 and CIc4, which is an output order in the 4_2 data output period DOP42, based on the output order of the second and fourth flag signals FS2 and FS4 in the 4_2 flag period FP32.

In the 4_2 data output period DOP42, the second non-volatile memory device 300_2 and the fourth non-volatile memory device 300_4 may output 4-bit current information codes in the order of the second current information code CIc2 to the fourth current information code CIc4, with the 4_2 flag period FP42 as a reference.

Each of the second non-volatile memory device 300_2 and the fourth non-volatile memory device 300_4 may output the current information codes with a unit of four clock cycles Cyc in the order of the second current information code CIc2 to the fourth current information code CIc4, based on the count value of the counter 3114.

During the 4_2 data output period DOP42, the first non-volatile memory device 300_1 may not output a current information code, and therefore, the second non-volatile memory device 300_2 and the fourth non-volatile memory device 300_4 may output the second and fourth current information codes CIc2 and CIc4 before the first non-volatile memory device 300_1 does. Similarly, during the 4_2 data output period DOP42, the third non-volatile memory device 300_3 may not output a current information code, and thus the fourth non-volatile memory device 300_4 may output the fourth current information code CIc4 before the third non-volatile memory device 300_3 does.

As an example, referring to FIG. 15, the second non-volatile memory device 300_2 may preferentially output the second current information code CIc2 having at least four clock cycles Cyc at t79, which is a time point of the 4_2 data output period DOP42, and the fourth non-volatile memory device 300_4 may output the fourth current information code CIc4 having at least four clock cycles Cyc at t80.

As an example, referring to FIG. 15, in the 4_2 data output period DOP12, the second current information code CIc2 may be 4b' 1001 and may correspond to the ninth memory operation OP9 with the current information table CIT of FIG. 6 as a reference. In the 4_2 data output period DOP12, the fourth current information code CIc4 may be 4b'0111 and may correspond to the seventh memory operation OP7 with the current information table CIT as a reference.

The storage device 100 according to one or more embodiments may output the header signal HS in the flag periods FP41 and FP42 to facilitate distinction between the flag periods FP41 and FP42 and the data output periods DOP41 and DOP42.

The storage device 100 according to one or more embodiments may efficiently output a current information code to a shared data line Lc by reducing unnecessary output of the current information code through an output of a flag signal, which is a reservation signal for the current information code.

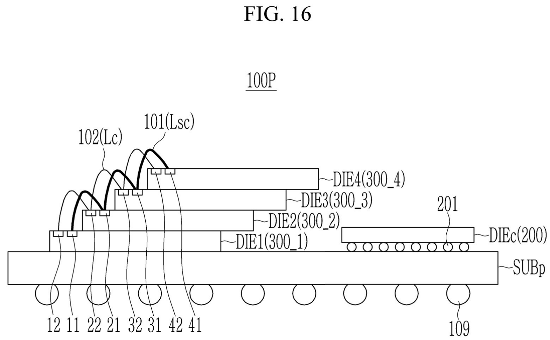

FIG. 16 illustrates a semiconductor package according to one or more embodiments. Specifically, FIG. 16 illustrates an embodiment in which the storage device 100 of FIG. 1 to FIG. 15 is implemented in a package form.

Referring to FIG. 16, a semiconductor package 100P may include a package substrate SUBp, a controller die DIEc, and a plurality of memory dies DIE1 to DIE4.

The controller die DIEc and the plurality of memory dies DIE1 to DIE4 may be arranged on an upper surface of the package substrate SUBp. In some embodiments, the package substrate SUBp may be a ceramic substrate, a printed circuit board (PCB), an organic substrate, an interposer substrate, and the like. In some embodiments, the package substrate SUBp may be referred to as a board, or a board substrate.

The controller die DIEc may be connected to the package substrate SUBp through a lower bump 201, and the package substrate SUBp may be redistributed by extending the lower bump 201 to an external region. Accordingly, the package substrate SUBp may be referred to as a redistribution substrate.

The controller die DIEc may transmit and/or receive a signal for a request and the like to an outside through an external connection terminal 109 disposed at a bottom of the package substrate SUBp and the lower bump 201. The controller die DIEc may correspond to the controller 200 of FIG. 1 to FIG. 15, and the description for the controller 200 of FIG. 1 to FIG. 15 may be applied.

The plurality of memory dies DIE1 to DIE4 may be stacked on the package substrate SUBp in a direction perpendicular to the package substrate SUBp, and at least some of the plurality of memory dies DIE1 to DIE4 may overlap each other on a plane (or when viewed in a plan view). For example, in FIG. 16, the plurality of memory dies DIE1 to DIE4 may be stacked in the order of first to fourth memory dies DIE1 to DIE4.

Each of the plurality of memory dies DIE1 to DIE4 may be connected to each other through a 1_1 pad 11 to a 4_1 pad 41 and a first wire 101 connected to the 1_1 pad 11 to the 4_1 pad 41 arranged on each of the plurality of memory dies DIE1 to DIE4. Additionally, each of the plurality of memory dies DIE1 to DIE4 may be connected to each other via a second wire 102 connected to a 1_2 pad 12 to a 4_2 pad 42 and a 2_2 pad 12 to the 4_2 pad 42 arranged on each of the plurality of memory dies DIE1 to DIE4.

The first to fourth memory dies DIE1 to DIE4 may correspond to the first non-volatile memory device 300_1 to the fourth non-volatile memory device 300_4 of FIG. 1 to FIG. 15, and the description for the first non-volatile memory device 300_1 to the fourth non-volatile memory device 300_4 of FIG. 1 to FIG. 15 may be applied. The first wire 101 and the second wire 102 may correspond to the shared clock line Lsc and the shared data line Lc of FIG. 1 to FIG. 15, respectively, and the descriptions for the shared clock line Lsc and the shared data line Lc of FIG. 1 to FIG. 15 may be applied.

The first to fourth memory dies DIE1 to DIE4 may output and share flag signals and current information codes through the first wire 101 and the second wire 102. The semiconductor package 100P may avoid an overlap in peak power periods without arranging complex dedicated circuits on the controller die DIEc through the first wire 101 and the second wire 102.

As in the operation of the storage device 100 of FIG. 1 to FIG. 15, the first to fourth memory dies DIE1 to DIE4 may output the flag signal, which is a reservation signal for the current information code, through the second wire 102, thereby reducing the output of an unnecessary current information code and efficiently outputting the current information code on the second wire 102.

As in the operation of the storage device 100 of FIG. 1 to FIG. 15, the first to fourth memory dies DIE1 to DIE4 may efficiently activate the flag period and the data output period of the current information code when input/output of the shared input/output line IOs are required, thereby improving the power efficiency and operational efficiency for the first and second wires 101 and 102.

Although not shown in FIG. 16, the controller die DIEc may be connected to the first to fourth memory dies DIE1 to DIE4 via wires corresponding to the first to fourth input/output lines IOd1 to IOd4 of FIG. 2, and may transmit and/or receive signals for commands, addresses, data, and the like via the wires, but is not limited thereto.

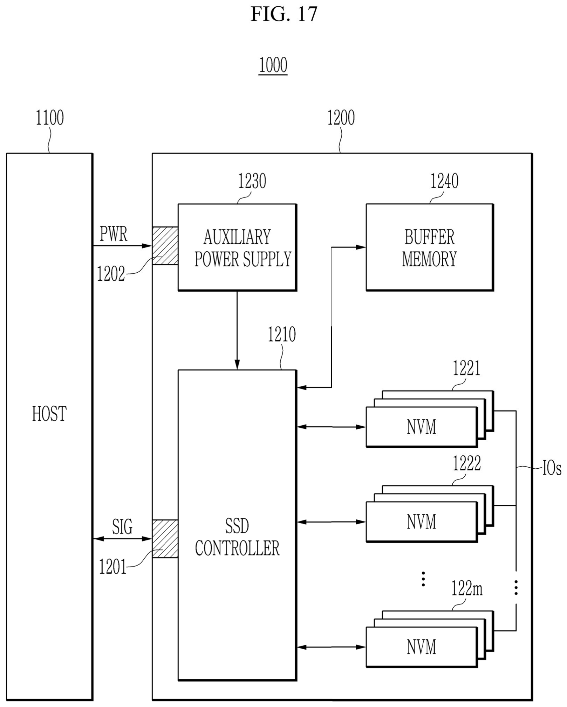

FIG. 17 is a block diagram of a solid state drive (SSD) system to which the storage device according to one or more embodiments is applied.

Referring to FIG. 17, an SSD system 1000 may include a host 1100 and an SSD 1200. The SSD 1200 may exchange a signal SIG with the host 1100 through a signal connector 1201 and receive power PWR input through a power connector 1202. The SSD 1200 may include an SSD controller 1210, a plurality of flash memories 1221 to 122m, an auxiliary power supply 1230, and a buffer memory 1240. The plurality of flash memories 1221 to 122m may be each connected to the SSD controller 1210 via a plurality of channels.

The SSD controller 1210 may control the plurality of flash memories 1221 to 122m in response to the signal SIG received from the host 1100. The SSD controller 1210 may store signals generated internally and/or transmitted from an outside (e.g., the signals SIG received from the host 1100) in the buffer memory 1240.

The plurality of flash memories 1221 to 122m may operate under control of the SSD controller 1210. The plurality of flash memories 1221 to 122m may be connected to each other via the shared input/output line IOs, and the plurality of flash memories 1221 to 122m may be implemented by the plurality of non-volatile memory devices 300_1 to 300_4 described with reference to FIG. 1 to FIG. 15. The shared input/output line IOs may correspond to the shared input/output line IOs of FIG. 1 to FIG. 15, and the description of the shared input/output line IOs of FIG. 1 to FIG. 15 may be applied.

The plurality of flash memories 1221 to 122m may output and share flag signals and current information codes with each other through the shared input/output line IOs. The SSD 1200 may avoid an overlap of peak power periods without arranging the complex dedicated circuit in the SSD controller 1210 through the shared input/output line IOs.

As in the operation of the plurality of non-volatile memory devices 300_1 to 300_4 of FIG. 1 to FIG. 15, the plurality of flash memories 1221 to 122m may output a flag signal, which is a reservation signal for the current information code, through the shared input/output line IOs, thereby reducing an output of an unnecessary current information code and efficiently outputting the current information code to the shared input/output line IOs.

As in the operation of the plurality of non-volatile memory devices 300_1 to 300_4 of FIG. 1 to FIG. 15, the plurality of flash memories 1221 to 122m may efficiently activate the flag period and the data output period of the current information code when the input/output of the shared input/output line IOs is required, thereby improving the power efficiency and operation efficiency for the shared input/output line IOs.

The auxiliary power supply 1230 may be connected to the host 1100 via the power connector 1202. The auxiliary power supply 1230 may receive the power PWR input from the host 1100 and charge the SSD 1200. The auxiliary power supply 1230 may provide power to the SSD 1200 when the power supply from the host 1100 is not smooth.

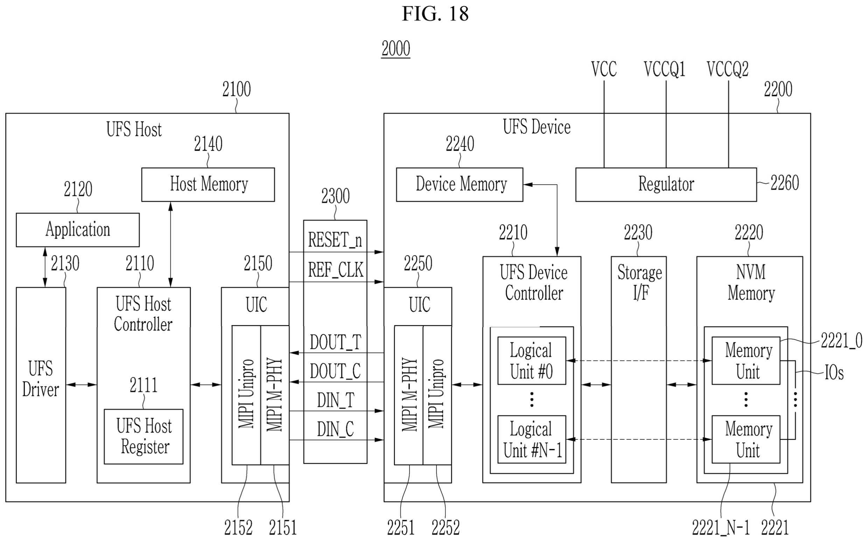

FIG. 18 is a block diagram of a universal flash storage (UFS) system according to one or more embodiments.

An UFS system 2000 may be a system that follows a UFS standard published by Joint Electron Device Engineering Council (JEDEC) and may include a UFS host 2100, a UFS device 2200, and a UFS interface 2300. The description of the user system 10 of FIG. 1 to FIG. 15 above may also be applied to the UFS system 2000 of FIG. 18 to the extent that it does not conflict with the description of FIG. 18 below.

Referring to FIG. 18, the UFS host 2100 may include a UFS host controller 2110, an application 2120, a UFS driver 2130, a host memory 2140, and a UFS interconnect (UIC) layer 2150. The UFS device 2200 may include a UFS device controller 2210, a non-volatile memory 2220, a storage interface 2230, a device memory 2240, a UIC layer 2250, and a regulator 2260. The non-volatile memory 2220 may include a plurality of memory units 2221_0 to 2221_N-1, and the plurality of memory units 2221_0 to 2221_N-1 may include a V-NAND flash memory of a two-dimensional (2D) structure or a three-dimensional (3D) structure, but may also include other types of non-volatile memory such as a PRAM and/or an RRAM. The UFS device controller 2210 and the non-volatile memory 2220 may be connected to each other through the storage interface 2230. The storage interface 2230 may be implemented to comply with standard protocols such as Toggle or ONFI.

The plurality of memory units 2221_0 to 2221_N-1 may be implemented by the plurality of non-volatile memory devices 300_1 to 300_4 described above with reference to FIG. 1 to FIG. 15, and the plurality of memory units 2221_0 to 2221_N-1 may be connected to each other via the shared input/output line IOs. The shared input/output line IOs may correspond to the shared input/output line IOs of FIG. 1 to FIG. 15, and the description of the shared input/output line IOs of FIG. 1 to FIG. 15 may be applied.

Each of the plurality of memory units 2221_0 to 2221_N-1 may include a memory cell array (not shown) and a control circuit (not shown) for controlling operation of the memory cell array and delaying operation of the memory cell array to avoid an overlap of the peak period. The memory cell array may include a two-dimensional memory cell array or a three-dimensional memory cell array. The three-dimensional memory cell array may include vertical NAND strings that are vertically oriented such that at least one memory cell is disposed above another memory cell.

The plurality of memory units 2221_0 to 2221_N-1 may output and share the flag signal and the current information code with each other through the shared input/output line IOs. The UFS device 2200 may avoid an overlap between peak power periods without arranging the complex dedicated circuits in the UFS device controller 2210 through the shared input/output line IOs.

As in the operation of the plurality of non-volatile memory devices 300_1 to 300_4 of FIG. 1 to FIG. 15, the plurality of memory units 2221_0 to 2221_N-1 may output the flag signal, which is a reservation signal for the current information code, through the shared input/output line IOs, thereby reducing the output of an unnecessary current information code and efficiently outputting the current information code to the shared input/output line IOs.

As in the operation of the plurality of non-volatile memory devices 300_1 to 300_4 of FIG. 1 to FIG. 15, the plurality of memory units 2221_0 to 2221_N-1 may efficiently activate the flag period and the data output period of the current information code when the input/output of the shared input/output line IOs is required, thereby improving the power efficiency and operation efficiency for the shared input/output line IOs.

The application 2120 may refer to a program that wants to communicate with the UFS device 2200 in order to utilize the functions of the UFS device 2200. The application 2120 may transmit an input/output request IOR to the UFS driver 2130 for input/output to the UFS device 2200. The input/output request IOR may mean a request to read data, a request to write data and/or a request to discard data, but is not limited thereto.

The UFS driver 2130 may manage the UFS host controller 2110 through a host controller interface (UFS-HCI). The UFS driver 2130 may convert input/output requests generated by the application 2120 into UFS commands defined by the UFS standard and transmit the converted UFS commands to the UFS host controller 2110. A single input/output request may be converted into a plurality of UFS instructions. The UFS command may be a command defined primarily by the SCSI standard, but it may also be an instruction exclusive to the UFS standard.

The UFS host controller 2110 may transmit the UFS command converted by the UFS driver 2130 to the UIC layer 2250 of the UFS device 2200 through the UIC layer 2150 and the UFS interface 2300. In this process, the UFS host register 2111 of the UFS host controller 2110 may serve as a command queue (CQ).

The UIC layer 2150 on the UFS host 2100 side may include an MIPI M-PHY 2151 and an MIPI UniPro 2152, and the UIC layer 2250 on the UFS device 2200 side may also include an MIPI M-PHY 2251 and an MIPI UniPro 2252.

The UFS interface 2300 may include a line used for transmitting a reference clock REF_CLK, a line used for transmitting a hardware reset signal RESET_n for the UFS device 2200, a pair of lines used for transmitting a differential input signal pair DIN_t and DIN_c, and a pair of lines used for transmitting a differential output signal pair DOUT_t and DOUT_c.

A frequency value of the reference clock provided from the UFS host 2100 to the UFS device 2200 may be one of four values: 19.2MHz, 26MHz, 38.4MHz, and 52MHz, but is not necessarily limited thereto. The UFS host 2100 may change the frequency value of the reference clock while the UFS host 2100 is in operation, that is, while data transmitting and/or receiving is performed between the UFS host 2100 and the UFS device 2200. The UFS device 2200 may generate clocks of various frequencies from the reference clock provided by the UFS host 2100 using a phase-locked loop (PLL) and the like. In addition, the UFS host 2100 may also set a data rate value between the UFS host 2100 and the UFS device 2200 through the frequency value of the reference clock. That is, the value of the data rate may be determined depending on the frequency value of the reference clock.

The UFS interface 2300 may support a plurality of multiple lanes, and each lane may be implemented as a differential pair. For example, the UFS interface may include one or more receive lanes and one or more transmit lanes. In FIG. 18, a pair of lines transmitting a differential input signal pair DIN_T and DIN_C may form a receive lane, and a pair of lines transmitting a differential output signal pair DOUT_T and DOUT_C may form a transmit lane. FIG. 18 illustrates one transmit lane and one receive lane, but a number of transmit lanes and receive lanes may be variously changed.

The receive lane and the transmit lane may transmit data in a serial communication manner, and full-duplex communication between the UFS host 2100 and the UFS device 2200 may be possible through a structure in which the receive lane and transmit lane are separated. That is, the UFS device 2200 may transmit data to the UFS host 2100 through the transmit lane while receiving data from the UFS host 2100 through the receive lane. In addition, control data such as commands from the UFS host 2100 to the UFS device 2200 and user data that the UFS host 2100 wants to store in the non-volatile memory 2220 of the UFS device 2200 or read from the non-volatile memory 2220 may be transmitted through the same lane. Accordingly, there is no need to provide a separate lane for data transmission other than a pair of receive lanes and a pair of transmit lanes between the UFS host 2100 and the UFS device 2200.

The UFS device controller 2210 of the UFS device 2200 may control the overall operation of the UFS device 200. The UFS device controller 2210 may manage the non-volatile memory 2220 through the logical unit (LU) 2211, which is a logical data storage unit. The number of LU 2211 may be 4 or 8, but is not limited thereto. The UFS device controller 2210 may include a flash translation layer (FTL) and may use address mapping information of the FTL to convert a logical data address, for example, a logical block address (LBA), transmitted from the UFS host 2100 into a physical data address, for example, a physical block address (PBA). In the UFS system 2000, a logical block for storing user data may have a size within a certain range. For example, the minimum size of the logical block may be set to 4 Kbytes.

When a command from the UFS host 2100 is input to the UFS device 2200 through the UIC layer 2250, the UFS device controller 2210 may perform an operation according to the input command, and when the operation is completed, a completion response may be transmitted to the UFS host 2100.

As an example, when the UFS host 2100 wants to store user data in the UFS device 2200, the UFS host 2100 may transmit a data storage command to the UFS device 2200. When a response indicating that user data is ready to be transferred (ready-to-transfer) is received from the UFS device 2200, the UFS host 2100 may transmit the user data to the UFS device 2200. The UFS device controller 2210 may temporarily store received user data in the device memory 2240, and store the user data temporarily stored in the device memory 2240 in a selected position of the non-volatile memory 2220 based on the address mapping information of the FTL.

As another example, when the UFS host 2100 wants to read user data stored in the UFS device 2200, the UFS host 2100 may transmit a data read command to the UFS device 2200. The UFS device controller 2210, which receives the command, may read user data from the non-volatile memory 2220 based on the data read command and temporarily store the read user data in the device memory 2240. During such a read process, the UFS device controller 2210 may detect and correct errors in the read user data using a built-in error correction code (ECC) engine (not shown). More specifically, the ECC engine may generate parity bits for write data to be written to the non-volatile memory 2220, and the parity bits generated in this way may be stored in the non-volatile memory 2220 together with the write data. When reading data from the non-volatile memory 2220, the ECC engine may correct errors in the read data using the parity bits read from the non-volatile memory 2220 together with the read data, and output the read data with the corrected errors.

In addition, the UFS device controller 2210 may transmit the user data temporarily stored in the device memory 2240 to the UFS host 2100. Additionally, the UFS device controller 2210 may further include an advanced encryption standard (AES) engine (not shown). The AES engine may perform at least one of an encryption operation and a decryption operation on data input to the UFS device controller 2210 using a symmetric key algorithm.

The UFS host 2100 may sequentially store commands to be transmitted to the UFS device 2200 in the UFS host register 2111, which may serve as a command queue, and transmit the command to the UFS device 2200 in the sequential order. In this case, the UFS host 2100 may transmit the next command waiting in the command queue to the UFS device 2200 even if the previously transmitted command is still being processed by the UFS device 2200, that is, even before receiving a command that the previously transmitted command has been completed by the UFS device 2200, and accordingly, the UFS device 2200 may also receive the next command from the UFS host 2100 even while processing the previously transmitted command. A queue depth of commands that can be stored in such a command queue may be, for example, 32. In addition, the command queue may be implemented as a circular queue type that indicates the start and end of the command sequence stored in the queue through the head pointer and tail pointer, respectively.

For the UFS device 2200, VCC, VCCQ, VCCQ2, and the like may be input as a power source voltage. VCC is a main power source voltage for the UFS device 2200 and may have a value of 2.4 V to 3.6 V. VCCQ is a power source voltage for supplying a low range voltage, mainly for the UFS device controller 2210, and may have a value of 1.14 V to 1.26 V. VCCQ2 is a power source voltage that supplies a voltage range lower than VCC but higher than VCCQ. It is mainly for an input/output interface such as the MIPI M-PHY 1251, and may have a value of 1.7 V to 1.95 V. The power source voltage may be supplied to each component of the UFS device 2200 through the regulator 2260. The regulator 2260 may be implemented as a set of unit regulators, each connected to a different one of the aforementioned power source voltages.

## Claims

1. A storage device (100) comprising:
a first non-volatile memory device (300_1) that includes a first memory cell array (320_1) including a plurality of first memory cells; and a first current management circuit (311_1) configured to output a shared clock signal (CLKs) to a shared clock line (Lsc); and
a second non-volatile memory device (300_2) that includes a second memory cell array (320_2) including a plurality of second memory cells; and a second current management circuit (311_2) configured to receive the shared clock signal (CLKs) from the shared clock line (Lsc), and preferentially output, in synchronization with the shared clock signal (CLKs), a second current information code (CIc2) of a second memory operation for the plurality of second memory cells to a shared data line (Lc) during a first data output period.

2. The storage device of claim 1, wherein the first current management circuit (311_1) is configured not to output first current information code (CIc1) of a first memory operation for the plurality of first memory cells during the first data output period.

3. The storage device of claim 2, wherein, during a first flag period corresponding to the first data output period, the second current management circuit (311_2) is configured to output a second flag signal (FS2) for the second memory operation to the shared data line (Lc) and the first current management circuit (311_1) is configured not to output a first flag signal (FS1) for the first memory operation.

4. The storage device of claim 2 or 3, wherein, during a second data output period different from the first data output period, the first current management circuit (311_1) is configured to output the first current information code (CIc1) to the shared data line(Lc), and
wherein, during the second data output period, the second current management circuit (311_2) is configured to output the second current information code (CIc2) to the shared data line (Lc) after the first current information code (CIc1) is output from the first current management circuit (311_1).

5. The storage device of claim 4, wherein, during a second flag period corresponding to the second data output period, the first current management circuit (311_1) is configured to output a first flag signal (FS1) for the first memory operation to the shared data line (Lc), and
wherein, during the second flag period, the second current management circuit (311_2) is configured to output a second flag signal (FS2) to the shared data line (Lc) after the first flag signal (FS1) is output from the first current management circuit (311_1).

6. The storage device of claim 1 or 2, further comprising a third non-volatile memory device (300_3) configured to output a third current information code (CIc3) to the shared data line (Lc) after the second current information code (CIc2) is output from the second current management circuit (311_2), during the first data output period,
wherein, during a first flag period corresponding to the first data output period, the third non-volatile memory device (300_3) is configured to output a third flag signal (FS3) to the shared data line (Lc) after a second flag signal (FS2) for the second memory operation is output from the second current management circuit (311_2).

7. The storage device of claim 6, wherein the third non-volatile memory device (300_3) is configured to determine whether a memory operation for the third non-volatile memory device (300_3) is to be delayed based on the second current information code (CIc2) and the third current information code (CIc3) that are output during the first data output period.

8. The storage device of claim 1 or 2, wherein, during a first flag period corresponding to the first data output period, the second current management circuit(311_2) is configured to output a second flag signal(FS2) for the second memory operation to the shared data line(Lc), and
wherein the second current management circuit(311_2) is configured to output the second flag signal(FS2) during at least one clock cycle for the shared clock signal(CLKs) in the first flag period.

9. The storage device of claim 1 or 2, wherein, during the first data output period, the shared data line (Lc) is maintained at a high voltage as an inactive state, in response to the second current information code (CIc2) being output to the shared data line (Lc),
wherein during a first flag period corresponding to the first data output period, the second current management circuit (311_2) is configured to output a second flag signal (FS2) for the second memory operation to the shared data line(Lc), and
wherein, during the first flag period, the shared data line (Lc) is maintained at a low voltage as an inactive state.

10. The storage device of claim 1 or 2, wherein during a first flag period corresponding to the first data output period, the second current management circuit (311_2) is configured to output a second flag signal (FS2) for the second memory operation to the shared data line (Lc), and
wherein, during the first flag period, the first current management circuit (311_1) is configured to output a header signal (HS) for the first flag period to the shared data line (Lc) before the second flag signal (FS2) is output from the second current management circuit (311_2).

11. The storage device of any one of claims 1 to 10, wherein the first non-volatile memory device (300_1) is configured to receive a first command (CMD1) for a first memory operation for the plurality of first memory cells through a first command address line that is different from the shared data line (Lc), and receive first data for the first memory operation through a first data line different from the shared data line (Lc) and the first command address line.

12. The storage device of claim 1, further comprising a controller (200) that is connected with the first non-volatile memory device (300_1) through a first input/output line (IOd1) and connected with the second non-volatile memory device through a second input/output line (IOd2), the controller being on a package substrate (SUBp) in a form of a die,
wherein the first non-volatile memory device (300_1) is on the package substrate (SUBp) in a form of a die,
wherein the second non-volatile memory device (300_2) is on the package substrate (SUBp) in a form of a die, and at least a portion of the second non-volatile memory device (300_2) overlaps the first non-volatile memory device (300_1) on a plane, and
wherein the first non-volatile memory device (300_1) and the second non-volatile memory device (300_2) are connected to each other through the shared data line(Lc) in the form of a wire.

13. An operation method of a storage device (100) including a plurality of non-volatile memory devices (300_1~300_4), the operation method comprising:
receiving, by a corresponding non-volatile memory device among the plurality of non-volatile memory devices, a command for a memory operation from a controller (200);
receiving, by the corresponding non-volatile memory device through a shared data line (Lc), a preceding flag signal for a preceding non-volatile memory device among the plurality of non-volatile memory devices, during a flag period before performing the memory operation;
outputting, by the corresponding non-volatile memory device, a flag signal to the shared data line (Lc) during the flag period after receiving the preceding flag signal;
receiving, by the corresponding non-volatile memory device through the shared data line (Lc), a preceding current information code for the preceding non-volatile memory device during a data output period corresponding to the flag period;
outputting, by the corresponding non-volatile memory device, a current information code to the shared data line (Lc) after receiving the preceding current information code, during the data output period; and
delaying, by the corresponding non-volatile memory device, the memory operation based on the preceding current information code.

14. The operation method of the storage device of claim 13, wherein the plurality of non-volatile memory devices comprise a first non-volatile memory device (300_1), as the preceding non-volatile memory device, and a second non-volatile memory device that are connected through the shared data line (Lc),
wherein, during the flag period, the first non-volatile memory device (300_1) is configured to output a first flag signal (FS1) to the shared data line (Lc) before an output of the flag signal, and the second non-volatile memory device is configured not to output a signal.

15. The operation method of the storage device of claim 13 or 14, further comprising comparing a peak current sum of a preceding peak current value for the preceding current information code and a peak current value for the current information code with a predetermined threshold value(TH),
wherein the delaying the memory operation is performed in response to the peak current sum being greater than the predetermined threshold value.
